(19) Europäisches Patentamt
European Patent Office
Office européen des brevets

(11) **EP 4 642 211 A1**

(12) **EUROPEAN PATENT APPLICATION**
published in accordance with Art. 153(4) EPC

(43) Date of publication:
**29.10.2025 Bulletin 2025/44**

(51) International Patent Classification (IPC):
**H10N 15/00** (2023.01)    **G01N 27/00** (2006.01)
**H10N 10/10** (2023.01)

(21) Application number: **23906842.2**

(52) Cooperative Patent Classification (CPC):
**G01N 27/00; H10N 10/10; H10N 15/00**

(22) Date of filing: **12.12.2023**

(86) International application number:
**PCT/JP2023/044536**

(87) International publication number:
**WO 2024/135477 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.12.2022 JP 2022202688**
**27.07.2023 JP 2023122817**

(71) Applicant: **The University of Tokyo**
**Bunkyo-ku, Tokyo 113-8654 (JP)**

(72) Inventors:
• **SAITOH, Eiji**
**Tokyo 113-8654 (JP)**
• **KIKKAWA, Takashi**
**Tokyo 113-8654 (JP)**
• **FUJIMOTO, Yuto**
**Tokyo 113-8654 (JP)**
• **ARISAWA, Hiroki**
**Tokyo 113-8654 (JP)**

(74) Representative: **EIP**
**Fairfax House**
**15 Fulwood Place**
**London WC1V 6HU (GB)**

(54) **NON-LINEAR THERMOELECTRIC EFFECT MEASUREMENT DEVICE, NON-LINEAR THERMOELECTRIC EFFECT MEASUREMENT METHOD, NON-LINEAR THERMOELECTRIC EFFECT MEASUREMENT PROGRAM, RECORDING MEDIUM, TEMPERATURE-FLUCTUATING ENVIRONMENT POWER GENERATION ELEMENT, AND TEMPERATURE FLUCTUATION SENSOR**

(57)    There is provided a nonlinear thermoelectric effect measurement apparatus, a nonlinear thermoelectric effect measurement method, a nonlinear thermoelectric effect measurement program, a recording medium, a temperature fluctuation energy harvesting element, and a temperature fluctuation sensor that enables detection of temperature fluctuation by converting the temperature fluctuation into electric energy by way of a nonlinear thermal electric effect.

A nonlinear thermoelectric effect measurement apparatus for measuring a nonlinear thermoelectric effect occurring in a sample includes a temperature gradient generating unit configured to cause a temperature gradient in the sample and a potential difference measuring unit configured to measure a potential difference V generated in the sample. The temperature gradient generating unit includes a first heating part provided on one surface of the sample and a second heating part provided on the other surface facing the one surface of the sample and is configured to apply a first current $j_{c1}=I_{dc1}+I_1\sin(\omega t + \Phi)$ to the first heating part and a second current $j_{c2}=I_{dc2}+I_2\sin(\omega t)$ to the second heating part.

EP 4 642 211 A1

# FIG.1

100

NONLINEAR THERMOELECTRIC EFFECT MEASUREMENT APPARATUS

20 MAGNETIC FIELD APPLYING UNIT

30 TEMPERATURE GRADIENT GENERATING UNIT

40 POTENTIAL DIFFERENCE MEASURING UNIT

50 LOCK-IN DETECTING UNIT

60 PHASE CHANGE MEASURING UNIT

70 INTENSITY CALCULATING UNIT

30a

10

SAMPLE

30b

## Description

### Technical field

The present invention relates to a nonlinear thermoelectric effect measurement apparatus, a nonlinear thermoelectric effect measurement method, a nonlinear thermoelectric effect measurement program, a recording medium, a temperature fluctuation energy harvesting element, and a temperature fluctuation sensor.

### Background Art

Conventionally, energy harvesting (ambient power generation) which gathers various forms of energy in the surroundings and converts it into electric energy has been proposed. Further, as one type of energy harvesting, a technique for harvesting electrical energy from the ambient temperature difference caused by using a thermoelectric conversion element has also been proposed (e.g., see Patent Document 1).

### Related art documents

### Patent documents

[Patent Document 1] Japanese Patent Laid-Open Publication No. 2015-144212

### Summary of the invention

### Problem to be solved by the invention

A conventionally known thermoelectric conversion element converts a temperature difference generated in an object into electric energy by the Seebeck effect. Therefore, a steady macroscopic temperature gradient is indispensable for power generation because the sign of the generated electric field is reversed whenever temperature gradient reverses. As examples of an environment enabling power generation by using such a conventional thermoelectric conversion element, there is heat exhaustion from a vehicle using an internal combustion engine or heat exhaustion from a factory using a heating device. However, in an actual environment, there is no steady temperature gradient. In daily life, situations allowing power to be generated by using a conventional thermoelectric conversion element are limited.

Moreover, even in an environment where the temperature appears to be steady on the macro-scale, it is considered that the temperature gradient may change in time or space on the micro-scale. If a micro-scale temperature fluctuation can be converted into electrical energy even in environments where the temperature gradient changes, energy harvesting can be achieved in more environments.

Thus, in view of above-described conventional problems, an embodiment of the present invention provides a nonlinear thermal electric effect measurement apparatus, a nonlinear thermal electric effect measurement method, a nonlinear thermal electric effect measurement program, a recording medium, a temperature fluctuation power harvesting element, and a temperature fluctuation sensor that enables detection of temperature fluctuation by converting the temperature fluctuation into electric energy by way of a nonlinear thermoelectric effect.

### Means for solving the problem

In order to solve the above-described problems, a nonlinear thermoelectric effect measurement apparatus according to an embodiment of the present invention is a nonlinear thermoelectric effect measurement apparatus for measuring a nonlinear thermoelectric effect occurring in a sample. The nonlinear thermoelectric effect measurement apparatus is characterized by including a temperature gradient generating unit that generates a temperature gradient in the sample, and a potential difference measuring unit that measures a potential difference V generated in the sample. The temperature gradient generating unit includes a first heating unit provided on one surface of the sample and a second heating unit provided on the other surface of the sample facing the one surface and is configured to apply a first current $j_{c1}=I_{dc1}+I_1\sin(\omega t + \Phi)$ to the first heating unit and a second current $j_{c2}=I_{dc2}+I_2\sin(wt)$ to the second heating unit.

With such a nonlinear thermoelectric effect measurement apparatus according to an embodiment of the present invention, temperature fluctuation can be converted into electric energy and detected by a nonlinear thermoelectric effect by applying a magnetic field to the sample, causing a temperature gradient in the sample, and providing a DC current component, an AC current component, and a phase difference in the current flowing through the first and second heating parts.

Further, one aspect of the present invention includes a magnetic field applying unit for applying a magnetic field to the sample.

Further, one aspect of the present invention includes a lock-in detecting unit for detecting a component $V_{2\omega}$ of frequency $2\omega$ in the potential difference V.

Further, one aspect of the present invention includes a phase change measuring unit for obtaining the distribution of the component $V_{2\omega}$ by changing the $\Phi$.

Further, one aspect of the present invention, an intensity calculating unit for calculating a nonlinear thermoelectric intensity $\beta$ based on the distribution of the component $V_{2\omega}$ obtained by the phase change measuring unit.

Further, in order to solve the above-described problems, a nonlinear thermoelectric effect measurement method according to an embodiment of the present invention is a nonlinear thermoelectric effect measurement method for measuring a nonlinear thermoelectric effect occurring in a sample. The nonlinear thermoelectric effect measurement method is characterized by including a temperature gradient generating step of causing a temperature gradient in the sample and a potential difference measuring step of measuring a potential difference V generated in the sample. The temperature gradient generating step includes applying a first current $j_{c1}=I_{dc1}+I_1\sin(\omega t + \Phi)$ to a first heating part provided on one surface of the sample and applying a second current $j_{c2}=I_{dc2}+ I_2\sin(\omega t)$ to a second heating part provided on the other surface facing the one surface of the sample.

Further, in order to solve the above-described problems, a nonlinear thermoelectric effect measuring program according to an embodiment of the present invention is a nonlinear thermoelectric effect measuring program for causing a computer to measure a nonlinear thermoelectric effect occurring in a first direction of a sample. The program causes execution of a temperature gradient generating step for causing a temperature gradient in the sample by applying a first current $j_{c1}=I_{dc1}+I_1\sin(\omega t + \Phi)$ to a first heating part provided on one surface of the sample and applying a second current $j_{c2}=I_{dc2}+I_2\sin(wt)$ to a second heating part provided on the other surface facing the one surface of the sample, and a potential difference measuring step for measuring the potential difference V generated in the sample.

Further, in order to solve the above-described problems, a computer-readable recording medium according to an embodiment of the present invention has the above-mentioned nonlinear thermoelectric effect measurement program recorded thereon.

Further, in order to solve the above-described problems, a temperature fluctuation energy harvesting element according to an embodiment of the present invention is characterized by including a thermoelectric conversion part that generates a potential difference from a temperature fluctuation due to a nonlinear thermoelectric effect and a spatial asymmetry part that breaks a spatial symmetry of the thermoelectric conversion part.

Further, according to one aspect of the present invention, the thermoelectric conversion part and the spatial asymmetry part are composed of different materials, and the thermoelectric conversion part and the spatial asymmetry part form a junction structure.

Further, according to one aspect of the present invention, the thermoelectric conversion part and the spatial asymmetry part are formed in the same material layer, and the material layer includes a crystal structure that has no inversion symmetry and belongs to a polar point group or a chiral point group.

Further, in order to solve the above-described problems, a temperature fluctuation sensor according to an embodiment of the present invention is characterized by including a thermoelectric conversion part that generates a potential difference from a temperature fluctuation due to a nonlinear thermoelectric effect, and a spatial asymmetry part that breaks the spatial symmetry of the thermoelectric conversion part.

Further, according to one aspect of the present invention, the thermoelectric conversion part and the spatial asymmetry part are composed of different materials, and the thermoelectric conversion part and the spatial asymmetry part form a junction structure.

Further, according to an aspect of the present invention, the thermoelectric conversion part and the spatial asymmetry part are formed in the same material layer, and the material layer includes a crystal structure that has no inversion symmetry and belongs to a polar point group or a chiral point group.

## Effects of the invention

In the present invention, it is possible to provide a nonlinear thermoelectric effect measurement apparatus, a nonlinear thermoelectric effect measurement method, a nonlinear thermoelectric effect measuring program, a recording medium, a temperature fluctuation environment power generating element, and a temperature fluctuation sensor that enables detection of temperature fluctuation by converting the temperature fluctuation into electric energy by way of a nonlinear thermoelectric effect.

## Brief description of the drawings

FIG. 1 is a block diagram showing a configuration of a nonlinear thermoelectric effect measurement apparatus 100 according to the first embodiment.

FIG. 2 is a step diagram showing the steps of a nonlinear thermoelectric effect measurement method according to the first embodiment.

FIG. 3 is a schematic diagram for explaining the measuring of a sample 10 using the nonlinear thermoelectric effect measurement apparatus 100 according to the first embodiment. FIG. 3 (a) shows an example of the sample 10, FIG. 3 (b) is a conceptual diagram showing the relation between a magnetic field B, a heat flow $j_Q$, and an electric field E.

FIG. 4 are substitute photographs substituting for drawings which show the states of setting the sample 10 in the nonlinear thermoelectric effect measurement apparatus 100 according to the first embodiment. Figs. 4 (a), 4(b) are examples illustrating a heat sink contacting both sides of the heaters 30a, 30b. Figs. 4 (c) (d) are examples illustrating a heat sink contacting only on one of the heaters 30a, 30b.

FIG. 5 are graphs showing the detection result by the lock-in detecting unit 50 according to the first embodiment. FIG. 5 (a) shows the first-order result of the heat flow. FIG. 5 (b) shows the result of $4\omega$ measurement. FIG. 5 (c) shows the second-order measurement result of the heat flow.

FIG. 6 is a graph showing the distribution of a voltage signal $V_{2\omega}$ obtained by changing the phase difference $\Phi$ of the AC current flowing through the heaters 30a, 30b according to the first embodiment.

FIG. 7 is a graph showing the distribution of the voltage signal $V_{2\omega}$ at various magnetic fields B.

FIG. 8 is a diagram showing spontaneous power generation caused in a sample 10 by temperature fluctuation. The upper side of FIG. 8 (a) is a graph showing vacuum degree and temperature fluctuation. The lower side of FIG. 8 (a) is a schematic diagram showing dc voltage occurring in the sample 10. FIG. 8(b) is a graph showing dc voltage caused in the sample 10 by temperature fluctuation.

FIG. 9 is a graph showing a peak amplitude $A_{dc}$ of dc voltage due to temperature fluctuation in FIG. 8.

FIG. 10 is a graph showing a relationship between the distribution of the magnitude of heat flow and a voltage signal $V_{2\omega}$. FIG. 10 (a) shows the distribution of a voltage signal $V_{2\omega}$ by various current values applied to heaters 30a, 30b. FIG. 10 (b) shows the relationship between the linear thermoelectric signal intensity and the nonlinear thermoelectric signal intensity.

FIG. 11 is a graph showing the secondary measurement results of the heat flow at a lock-in detecting unit 50 at various temperatures.

FIG. 12 is a schematic diagram showing a crystal structure of Te which is a sample 10 according to the fourth embodiment.

FIG. 13 is a schematic diagram for explaining the measuring of a sample 10 according to the fourth embodiment.

FIG. 14 are graphs showing the magnetic field dependence of linear and nonlinear Seebeck coefficients $S^{(1)}$, $S^{(2)}$. FIG. 14 (a) shows a first order term $S^{(1)}$ in 20K. FIG. 14(b) shows a second order term $S^{(2)}$ in 20K. FIG. 14(c) shows a first order term $S^{(1)}$ in 300K. FIG. 14 (d) shows a second order term $S^{(2)}$ in 300K.

FIG. 15 are graphs showing the chemical potential dependence of linear and nonlinear Seebeck coefficients $S^{(1)}$, $S^{(2)}$. FIG. 15(a) shows a first order term $S^{(1)}$ at low temperatures. FIG. 15(b) shows a second order term $S^{(2)}$ at low temperatures. FIG. 15(c) shows a first order term $S^{(1)}$ at high temperatures. FIG. 15(d) shows a second order term $S^{(2)}$ at high temperatures.

FIG. 16 are graphs showing the temperature dependence of linear and nonlinear Seebeck coefficients $S^{(1)}$, $S^{(2)}$. FIG. 16 (a) shows a first order term $S^{(1)}$ in a low temperature range. FIG. 16 (b) shows a second order term $S^{(2)}$ in a low temperature range. FIG. 16 (c) shows a first order term $S^{(1)}$ in a high temperature range. FIG. 16 (d) shows a second order term $S^{(2)}$ in a high temperature range.

**Modes for carrying out the invention**

(First embodiment)

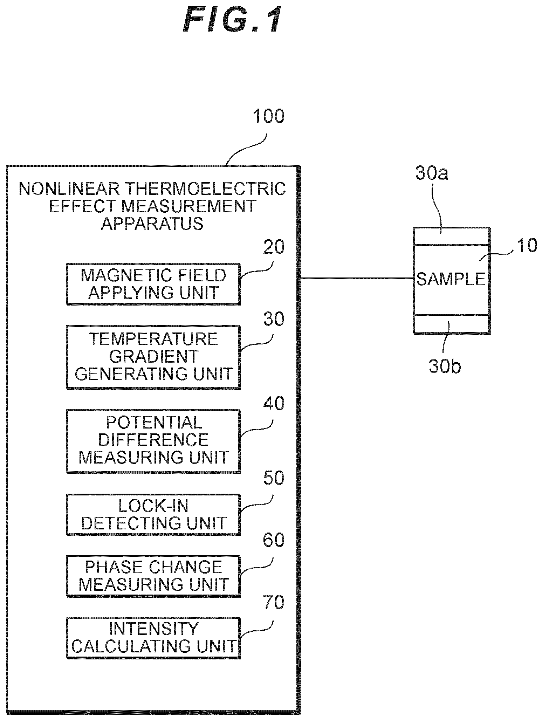

Hereinafter, embodiments of the present invention are described in detail with reference to the drawings. Identical or equivalent components, members, and processes shown in the drawings shall be denoted by the same reference numerals, and redundant description thereof shall be omitted as appropriate. FIG. 1 is a block diagram showing a configuration of a nonlinear thermoelectric effect measurement apparatus 100 according to the present embodiment. A nonlinear thermoelectric effect measurement apparatus 100 has each of its hardware controlled by a computer. The computer is a device for processing various kinds of information according to a predetermined procedure and includes a central processing unit (CPU: Central Processing Unit), a memory, an external storage device, and various interfaces. Further, the computer is connected to each hardware shown in FIG. 1 and uses various interfaces to perform information communication with the hardware. The computer controls operation of the hardware by sending control signals thereto and also obtains various information from the hardware.

As shown in FIG. 1, the nonlinear thermoelectric effect measurement apparatus 100 is an apparatus for measuring the nonlinear thermoelectric effect of a sample 10 and includes a magnetic field applying unit 20, a temperature gradient generating unit 30, a potential difference measuring unit 40, a lock-in detecting unit 50, a phase change measuring unit 60, and an intensity calculating unit 70. Each of these units is realized by the CPU which performs information processing based on the computer's memory and programs recorded in the external storage device and executes the steps of a nonlinear thermoelectric effect measurement method. Further, a program for executing the nonlinear thermoelectric effect measurement method with each of the units shown in FIG. 1 is recorded in a recording medium, so that the program may be read into the memory of the computer and the external storage device from the recording medium as necessary via an electric data communication line or the like.

The sample 10 is an object to be measured by the nonlinear thermoelectric effect measurement apparatus 100. Preferably, the sample 10 is formed of a material that is assumed to achieve a nonlinear thermoelectric effect. Although the structure of the sample 10 is not limited in particular, one example is a structure or a material that includes a thermoelectric conversion part that generates a potential difference from temperature fluctuation due to a nonlinear thermoelectric effect and a spatial asymmetry part that breaks a spatial symmetry of the thermoelectric conversion part. The thermoelectric conversion part and the spatial asymmetry part may be configured as a junction structure formed of different materials or configured as a layer of the same material.

The magnetic field applying unit 20 is a part that applies a magnetic field to the sample 10. The configuration of the magnetic field applying unit 20 is not limited in particular. Although an electromagnet or a permanent magnet may be used as the magnetic field applying unit 20, it is preferable to use an electromagnet to control the direction and intensity of the magnetic field. Although this embodiment illustrates an example of a configuration using the magnetic field applying unit 20 for facilitating the measurement of the nonlinear thermoelectric effect by applying a magnetic field, the magnetic field applying unit 20 may be omitted from the configuration.

The temperature gradient generating unit 30 is a part that causes a temperature gradient in the sample 10. Although the specific configuration of the temperature gradient generating unit 30 is not limited in particular, one example shown in FIG.1 includes heaters (heating parts) 30a, 30b on the front and back surfaces of the sample 10. Further, the temperature gradient generating unit 30 includes a heater power supply (not illustrated) for supplying a current to the heaters 30a, 30b. By controlling the current supplied from the heater power supply to the heaters 30a, 30b, the temperature gradient generating unit 30 temporally changes the temperature difference applied to the sample 10 and causes a temperature gradient between the two surfaces of the sample 10. As will be described below, the current applied from the temperature gradient generating unit 30 to the heating parts has its AC component superimposed with its DC component. Here, the heater 30a corresponds to a first heating unit according to an embodiment of the present invention, and the heater 30b corresponds to a second heating unit according to an embodiment of the present invention.

The potential difference measuring unit 40 is a part that measures the potential difference generated in the sample 10. Although the configuration of the potential difference measuring unit 40 is not limited in particular, one example has a configuration in which two electrodes are formed on opposite sides of the sample 10 in a direction perpendicular to the temperature gradient direction and the direction of the applied magnetic field, so that the potential difference between the electrodes can be measured with a voltmeter.

The lock-in detecting unit 50 is a part that performs lock-in detection of a predetermined frequency component from the time-dependent changes in the potential difference measured by the potential difference measuring unit 40. Although the specific configuration of the lock-in detecting unit 50 is not limited in particular, a conventionally known lock-in amplifier may be used.

The phase change measuring unit 60 is a part that provides a phase difference to the AC component of the current supplied to the heaters 30a, 30b. By changing the phase difference $\Phi$ of the AC component applied to the heaters 30a, 30b and measuring a predetermined frequency component of the potential difference generated in the sample 10 by using the potential difference measuring unit 40, the potential distribution in the phase difference $\Phi$ can be obtained.

The intensity calculating unit 70 is a part that calculates the nonlinear thermoelectric intensity $\beta$ based on the distribution of the predetermined frequency component obtained by the phase change measuring unit 60. The method of calculating the nonlinear thermoelectric intensity $\beta$ is described in detail below.

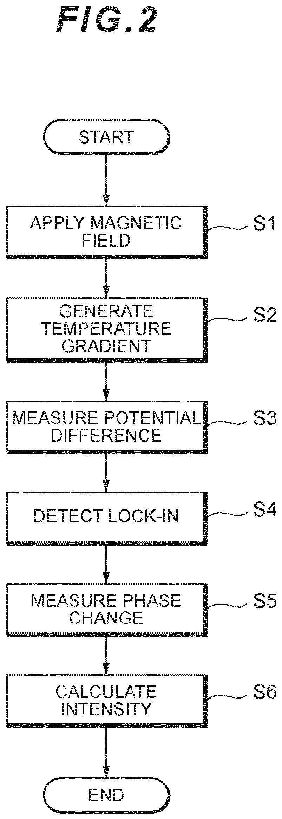

FIG. 2 is a process diagram showing the steps of a nonlinear thermoelectric effect measurement method according to the present embodiment. As shown in FIG. 2, the nonlinear thermoelectric effect measurement method starts with a state in which the sample 10 is placed in the nonlinear thermoelectric effect measurement apparatus 100 shown in FIG. 1 and the measurement environment (e.g., temperature, degree of vacuum) is set appropriately.

Step S1 is a magnetic field applying step in which a magnetic field is applied to the sample 10 from the magnetic field applying unit 20. Step S2 is a temperature gradient generating step in which a temperature gradient is caused in the sample 10 by the temperature gradient generating unit 30. Step S3 is a potential difference measuring step in which the potential difference generated in the sample 10 is measured by using the potential difference measuring unit 40. Step S4 is a lock-in detecting step in which a predetermined frequency component of the potential difference generated in the sample 10 is detected by using the lock-in detecting unit 50. Step S5 is a phase change measuring step in which a predetermined frequency component of the potential difference is measured with the phase change measuring unit 60 by changing the phase of the temperature gradient applied to the front and back surfaces of the sample 10 by the temperature gradient generating unit 30. Step S6 is an intensity calculation step in which the nonlinear thermoelectric intensity $\beta$ is calculated with the intensity calculating unit 70 based on the distribution of the predetermined frequency component obtained by the phase change measuring unit 60. Specific examples of each of the steps are described in detail below.

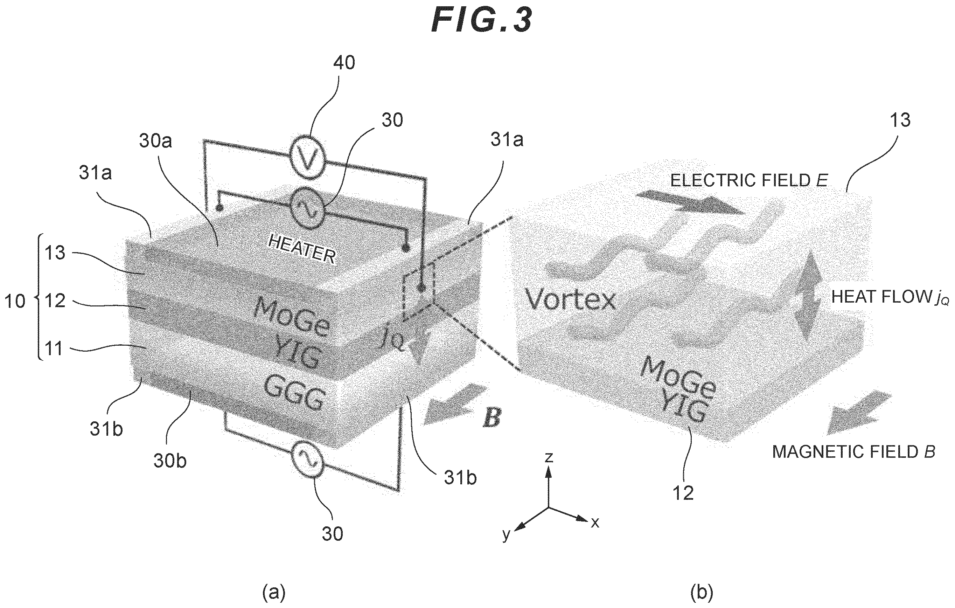

FIG. 3 is a schematic diagram for explaining the measuring of the sample 10 using the nonlinear thermoelectric effect measurement apparatus 100 according to the present embodiment. FIG. 3(a) shows an example of the sample 10. FIG. 3(b) is a conceptual diagram showing the relation between a magnetic field B, a heat flow jQ, and an electric field E. In the example shown in FIG. 3, the sample 10 has a stacked structure formed of a substrate 11, a magnetic insulating layer 12, and a superconducting material layer 13.

The substrate 11 is a substantially plate-shaped member for holding the magnetic insulating layer 12 and the superconducting material layer 13 and has one surface on which the magnetic insulating layer 12 and the superconducting material layer 13 are formed. Although the material of the substrate 11 is not limited in particular, a material that can form the magnetic insulating layer 12 is selected in this embodiment. FIG. 3 shows an embodiment using a $Gd_3Ga_5O_{12}$ (GGG) as the substrate 11. The thickness of the substrate 11 is, for example, 500 $\mu$m.

The magnetic insulating layer 12 is a layer made of an electrically insulating magnetic material and formed on the substrate 11. The magnetic insulating layer 12 has an upper surface on which the superconducting material layer 13 is formed. Although the material of the magnetic insulating layer 12 is not limited in particular, materials that can be formed on the substrate 11 are selected in this embodiment. FIG. 3 shows an embodiment using $Y_3Fe_5O_{12}$ (YIG) as the magnetic insulating layer 12. On the substrate 11 made of GGG, a magnetic insulating layer 12 made of YIG can be grown by using a conventionally known liquid phase epitaxial growth method. The thickness of the magnetic insulating layer 12 is, for example, 3 $\mu$m. Here, the magnetic insulating layer 12 is provided only on one surface side of the superconducting material layer 13 to form a structure that breaks the spatial symmetry when viewed from the superconducting material layer 13. Thus, the magnetic insulating layer 12 corresponds to the spatial asymmetry part according to an embodiment of the present invention.

The superconducting material layer 13 is a layer made of a superconducting material formed on the upper surface of the magnetic insulating layer 12. Although the material of the superconducting material layer 13 is not limited in particular, a material that can be formed on the magnetic insulating layer 12 is selected in this embodiment. FIG. 3 shows an exemplary case in which an amorphous MoGe that is a type 2 superconductor is used as the superconducting material layer 13. The superconducting material layer 13 made of MoGe can be formed on the magnetic insulating layer 12 by using a conventionally known high-frequency sputtering method. The thickness of the superconducting material layer 13 may be, for example, 150 nm. As an example of the conditions of the high-frequency sputtering method of MoGe, the Ar pressure may be $2.8 \times 10^{-1}$ Pa, the growth rate may be 5nm/min, and the rotational speed of the substrate 11 may be 3000 rpm while the substrate 11 is being water-cooled. Here, the superconducting material layer 13 corresponds to a thermoelectric conversion part according to an embodiment of the present invention because the superconducting material layer 13 is a layer in which a potential difference due to a thermoelectric effect occurs in a direction perpendicular to the temperature gradient and the magnetic field.

After growing the magnetic insulating layer 12 on the substrate 11 by the liquid phase epitaxial method and forming the superconducting material layer 13 on the magnetic insulating layer 12 by using the high-frequency sputtering method, it is diced into a device size of, for example, 6 mm $\times$ 3 mm. Thereby, the sample 10 shown in FIG. 3 10 is obtained. As will be described below, the junction structure of the magnetic insulating layer 12 and the superconducting material layer 13 allows a potential difference to occur by a nonlinear thermoelectric effect. Accordingly, the sample 10 shown in FIG.3 includes a thermoelectric conversion part that achieves a nonlinear thermoelectric effect and a spatial asymmetry part that breaks the spatial symmetry of the thermoelectric conversion part. Further, the thermoelectric conversion part and the spatial asymmetry part are composed of different materials. Further, the sample 10 includes a junction structure of the thermoelectric conversion part and the spatial asymmetry part. Thus, the sample 10 corresponds to a nonlinear thermoelectric effect element according to an embodiment of the present invention.

Further, a heater 30a and an electrode 31a are provided on the front surface of the superconducting material layer 13, and a heater 30b and an electrode 31b are provided on the back surface of the substrate 11. The heaters 30a, 30b are composed of, for example, a thin film resistor or the like, and generate Joule-heat by being supplied with a current. The heaters 30a, 30b are provided contacting the superconducting material layer 13 and the substrate 11, respectively, to produce a temperature gradient between the front and back surfaces of the sample by supplying heat to the front and back surface sides of the sample 10. The electrodes 31a, 31b are the parts made of metallic materials provided on both sides of the heaters 30a, 30b, respectively.

A heater power supply of the temperature gradient generating unit 30 is connected to each of the electrodes 31a, 31b, so that a current can be supplied to the heaters 30a, 30b. Further, electrodes (not shown) are also formed on the opposite side surface of the superconducting material layer 13 and connected to the potential difference measuring unit 40. Here, the heater 30a, 30b and the electrode 31a, 31b may be formed integrally with the front and back surfaces of the sample 10. Alternatively, the heater 30a, 30b and the electrode 31a, 31b may be constituted separately from the sample 10 and configured to hold the sample 10.

As shown in FIG. 3, the plane of the sample 10 in which the substrate 11 extends is assumed as the x-y plane, and the direction in which the substrate 11, the magnetic insulating layer 12, and the superconducting material layer 13 are stacked is assumed as the z-axis direction. The direction of the applied magnetic field B with the magnetic field applying unit 20 is assumed as the y-axis direction, and the direction in which the temperature gradient caused by the temperature gradient generating unit 30 is assumed as the z-axis direction. As shown in FIG. 3 (b), a magnetic flux quantized by the magnetic field B (vortex string: vortex) occurs in the superconducting material layer 13 in the y-axis direction. At this time, the electric field E is generated in the x - axis direction due to the thermoelectric effect by the heat flow $j_Q$ caused by a temperature gradient. Here, the x-axis direction, the y-axis direction, and the z-axis direction correspond to the first direction, the second direction, and the third direction, respectively, according to an embodiment of the present invention. In a case where a nonlinear thermal conductive effect is generated in the superconducting layer 13, the direction of the electric field E is the same regardless of whether the direction of the heat flow $j_Q$ is the positive direction or the negative direction of the z-axis as shown in FIG. 3(b).

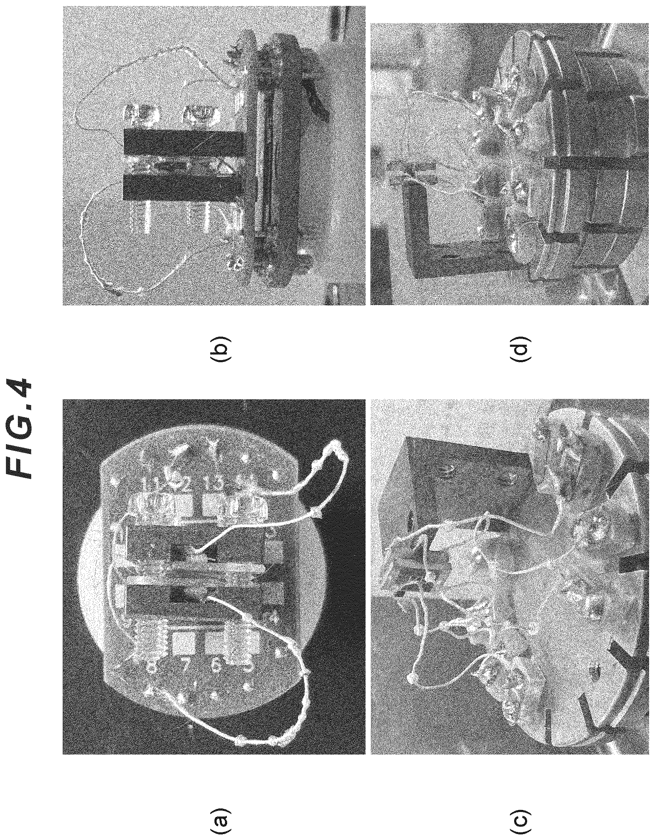

FIG.4 is a substitute photograph substituting for drawings which show the states of setting the sample 10 in the nonlinear thermoelectric effect measurement apparatus 100 according to this embodiment. FIGS. 4 (a), 4(b) are examples illustrating a heat sink contacting both sides of the heaters 30a, 30b. FIGS. 4 (c) (d) are examples illustrating a heat sink contacting only on one of the heaters 30a, 30b. Because the superconducting material layer 13 of the sample 10 measures the thermoelectric effect in the superconducting state, the nonlinear thermoelectric effect measurement apparatus 100 of the present embodiment accommodates a sample holder shown in FIGS. 4 (a) (b) or FIGS. 4 (c) (d) in a vacuum vessel and performs measurement while changing the magnetic field using a superconducting magnet in an ultra-low temperature environment.

Next, the linear (1st order) and nonlinear (2nd order) of the thermoelectric effect is described. With a conventionally known linear thermoelectric effect, the electric field E caused by a heat flow is expressed as the E = SVT by using the thermoelectric coefficient S and the temperature gradient $\nabla T (\propto$ heat flow $J_Q$). This relation reverses the sign of the electric field E when the orientation of the temperature gradient $\nabla T$ ($\propto$ heat flow $J_Q$) is reversed and satisfies the relation E (+VT) = -E (-VT). Therefore, with the conventional linear thermoelectric conversion, thermal power generation can only be achieved only under an environment in which a steady-state macroscopic temperature-gradient $\nabla T$ is present.

On the other hand, with the second-order thermoelectric effect, the nonlinear relation of $<E> = <S (\nabla T)^2 > \neq 0$ under the condition of broken spatial symmetry and the nonreciprocal relation of $|E(+\nabla T)| \neq |E(-\nabla T)|$ are satisfied. Thereby, it is considered that thermal power generation can be achieved from macroscopic temperature fluctuation even in an environment in which a steady macroscopic temperature gradient $\nabla T$ does not exist. The inventors of the present invention have succeeded for the first time in the world in measuring a secondary thermoelectric effect using the nonlinear thermoelectric effect measurement apparatus 100.

A thermoelectric signal V caused by a thermoelectric effect is expressed as [Formula 1] in a case where a heat flow $j_Q$ is used. Here, "$a^{(1)}$" is a linear (first order) term, and "$a^{(2)}$" is a nonlinear (second order) term.

[Formula 1]

$$V = a^{(1)} j_Q + a^{(2)} j_Q^2 + a^{(3)} j_Q^3 + \cdots$$

Because the Joule heat $j_Q$, which is generated when an alternating current $j_c \propto \sin(\omega t)$ of angular frequency $\omega$ is passed through the heaters 30a, 30b, is proportional to the square of the current, $j_Q$ is expressed as [Formula 2]. Further, [Formula 3] is obtained by substituting [Formula 2] into [Formula 1].

[Formula 2]

$$j_Q \propto j_c^2 \propto \sin^2(\omega t) \propto 1 - \cos(2\omega t)$$

[Formula 3]

$$V = a^{(1)}(1 - \cos(2\omega t)) + a^{(2)}(1 - \cos(2\omega t))^2 + a^{(3)}(1 - \cos(2\omega t))^3 + \cdots$$

$$= \{a^{(1)} + \cdots\}\cos(2\omega t) + \{a^{(2)} + a^{(3)} + \cdots\}\cos(4\omega t) + \{a^{(3)} + \cdots\}\cos(6\omega t) + \cdots$$

Therefore, in the potential difference V measured by the potential difference measuring unit 40, a voltage signal

$V_{2\omega}$ generated by the first order term (linear) $a^{(1)}$ of the heat flow can be measured by performing lock-in detection of the angular frequency $2\omega$ with the lock-in detecting unit 50. However, even if lock-in is detected at the angular frequency $4\omega$, the coefficient of $\cos(4wt)$ in [Formula 3] would include the second order term $a^{(2)}$ and the third-order term $a^{(3)}$. Thus, the nonlinear thermoelectric effect cannot be measured because the terms other than the second order term will also be included.

Therefore, $jc \propto I_{dc}+I_0\sin(\omega t)$ is obtained by adding a DC bias current $I_{dc}$ to the AC current supplied from the temperature gradient generating unit 30 to the heaters 30a, 30b. In this case, the Joule heat $j_Q$ generated is expressed as [Formula 4].

[Formula 4]

$$j_Q \propto (I_{dc}+I_0\sin(\omega t))^2 = I_{dc}^2 + 2I_{dc}\,I_0\sin(\omega t) + I_0^2\sin^2(\omega t)$$

Here, the term $\sin^2(\omega t)$ can be converted to $\cos(2\omega t)$ in the same manner as in [Formula 2], so that the first order term of the heat flow can be measured by lock-in detection with $2\omega$. Further, with respect to the second order term $a^{(2)}$ of [Formula 3], it is expressed as [Formula 5] and includes a term of $\sin(\omega t)$. Therefore, it can be measured by using a harmonic lock-in detection of angular frequency $2\omega$.

[Formula 5]

$$a^{(2)}\ (I_{dc}^2 + 2I_{dc}\,I_0\sin(\omega t) + I_0^2\sin^2(\omega t))$$

However, with the [Formula 3], the sine squared term of $a^{(1)}$ would also be included, and both the first order term (linear) $a^{(1)}$ and the second order term (nonlinear) $a^{(2)}$ would be included by the lock-in detection at angular frequency $2\omega$. Accordingly, it is difficult to extract only the second order term because the first order term is large. Therefore, a phase difference $\Phi$ is provided in the AC components supplied to the heaters 30a,30b. More specifically, the currents $j_{c1}$, $j_{c2}$ supplied to the heaters 30a, 30b are assumed as $j_{c1} \propto I_{dc1}+I_1\sin(\omega t + \Phi)$, $jc_2 \propto I_{dc2}+I_2\sin(\omega t)$, respectively. In this case, the heat flow $jQ$ is expressed by [Formula 6].

[Formula 6]

$$j_Q \propto I_{dc1}^2 + 2I_{dc1}I_1\sin(\omega t+\Phi) + I_1^2\sin^2(\omega t+\Phi) - I_{dc2}^2 - 2I_{dc2}I_2\sin(\omega t) - I_2^2\sin^2(\omega t)$$

Therefore, by setting $I_{dc1}$, $I_{dc2}$, $I_1$,$I_2$ so that only the first order term of sin remains in [Formula 6], the voltage $V^{2\omega}{}_{diff}$ generated by the second order term (nonlinear) $a^{(2)}$ of the heat flow can be measured by the lock-in detection with an angular frequency $2\omega$. In one exemplary process under the initial settings of $I_{dc1}=I_{dc2}$, $I_1=I_2$, $\Phi=0$, only the terms of $\sin(\omega t + \Phi)$ and $\sin(wt)$ in [Formula 6] are left to remain by repeating a step of eliminating the $2\omega$ lock-in voltage by changing $I_1$ and a step of eliminating the $1\omega$ lock-in voltage by changing $I_2$ with the use of the temperature gradient generating unit 30. Then, the distribution of the voltage signal $V_{2\omega}$ is obtained by changing $\Phi$ with the use of the phase change measuring unit 60.

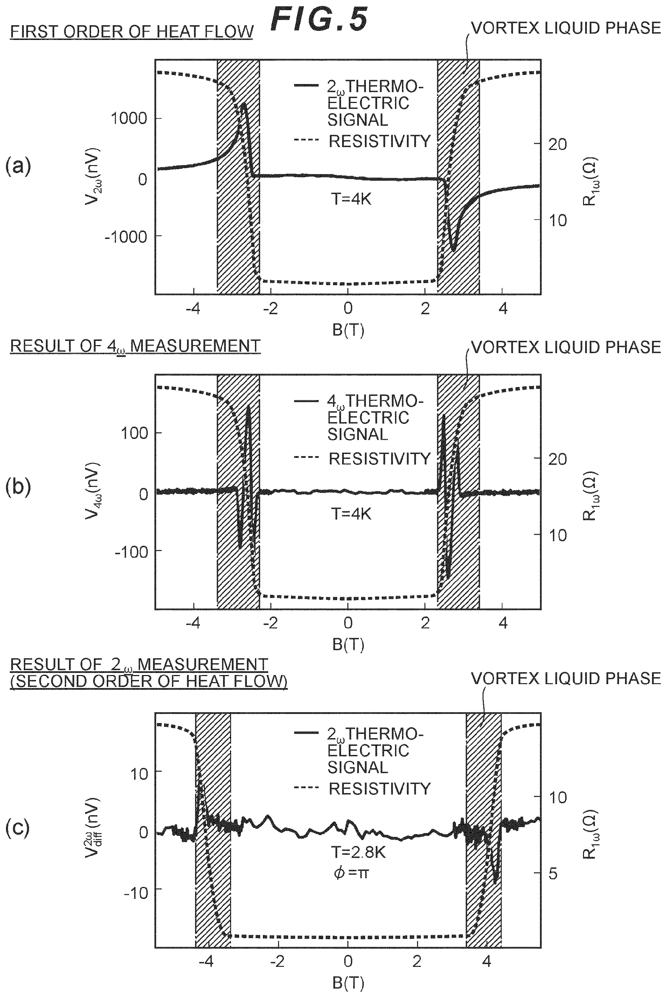

FIG. 5 are graphs showing the detection result by the lock-in detecting unit 50 according to this embodiment. FIG. 5 (a) shows the first order result of the heat flow. FIG. 5 (b) shows the result of $4\omega$ measurement. FIG. 5 (c) shows the second order measurement result of the heat flow. The horizontal axis in the figure indicates the magnetic field B applied by the magnetic field applying unit 20, the left vertical axis indicates the measured voltage by the potential difference measuring unit 40, and the right vertical axis indicates the electrical resistance value. Further, the solid line in the graph indicates the thermoelectric signal at the lock-in detecting unit 50, and the broken line indicates the electrical resistance value of the superconducting material layer 13. Further, "T" shown in the graph indicates the temperature for the measurement.

In each graph of FIG. 5(a) to FIG. 5(c), it can be seen that the magnetic field B is larger than the critical magnetic field, that the resistance value exists in the superconducting material layer 13, and that the superconducting material layer 13 is in a normal conducting state at both side regions of the horizontal axis in which the absolute values of the magnetic field B are large. Further, it can be seen that the magnetic field B is smaller than the critical magnetic field, that the resistance value of the superconducting material layer 13 is zero, and that the superconducting material layer 13 is in a superconducting state at a central region of the horizontal axis in which absolute values of the magnetic field B are small. The shaded region in Figures 5(a) to 5(c) is an intermediate state between the superconducting state and the normal conducting state and represents the vicinity of a phase transition magnetic field where the resistance value of the superconducting material layer 13 changes rapidly. In a case where the superconducting material layer 13 is in a superconducting state, a quantized magnetic flux (vortex string: vortex) is pinned in the superconducting material layer 13. However, in the vicinity of the phase transition temperature, the pinned quantized magnetic flux is released to become a vortex liquid phase (vortex liquid). Thereby, the vortex string can freely move in the superconducting material layer 13.

In the present embodiment, as shown in FIG.5(a), lock-in detection at angular frequency $2\omega$ is performed by the lock-in detecting unit 50, and the voltage $V_{2\omega}$ generated by the first order term $a^{(1)}$ of the above-described heat flow is measured. In the magnetic field region in the superconducting state, the voltage signal $V_{2\omega}$ is zero and no thermoelectric effect occurs in the first order term $a^{(1)}$ of the heat flow. This is considered to be because the vortex string is pinned in the superconducting material layer 13 in the superconducting state and the movement of the vortex string by the heat flow does not occur. On the other hand, in the vicinity of the phase transition magnetic field in the superconductive state, the voltage signal $V_{2\omega}$ rapidly changes. In the magnetic field region, it is considered that the pinned vortex string is released to become a vortex string liquid phase, and the movement of the vortex string is caused by the heat flow. Thereby, a potential difference is generated in the x-axis direction by a Nernst effect.

Further, as shown in FIG. 5 (b), when the lock-in detecting unit 50 performs lock-in detection at angular frequency $2\omega$, an abrupt change occurs in negative and positive of the voltage signal $V_{4\omega}$ in the vortex liquid phase. As described above, this is because the second order term $a^{(2)}$ and third-order term $a^{(3)}$ of the heat flow are both included. Thus, only the nonlinear second order term $a^{(2)}$ cannot be extracted.

As shown in FIG. 5 (c), in a case where a bias current and an alternating current are applied to the heaters 30a, 30b and a phase difference $\Phi$ ($\Phi = n$ in the example shown in FIG. 5 (c)) is provided in the alternating current, a distinct peak signal of the voltage signal $V^{2\omega}_{diff}$ appears in the vicinity of the phase transition magnetic field. This is considered to be because only the second order term $a^{(2)}$ of the heat flow is extracted by setting $I_{dc1}$, $I_{dc2}$, $I_1$, and $I_2$ to allow only the terms of $\sin(\omega t + \Phi)$ and $\sin(\omega t)$ to remain in [Formula 6]. Further, the distribution of the voltage signal $V^{(2)}_{2\omega}$ should be the relationship of [Formula 7] because $I_{dc1}$, $I_{dc2}$, $I_1$, and $I_2$ are set to allow only the terms of $\sin(\omega t + \Phi)$ and $\sin(\omega t)$ to remain in [Formula 6].

## [Formula 7]

$$V_{2\omega}^{(2)} \propto \sin^2(\phi/2)\cos(\phi)$$

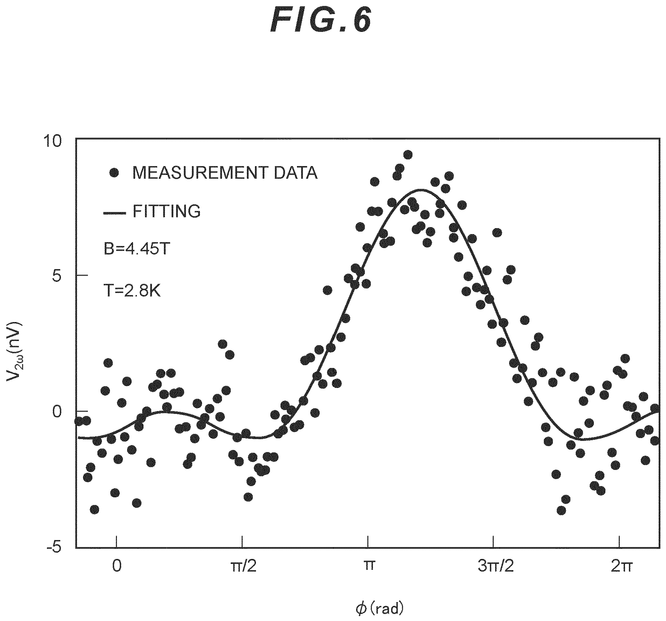

FIG. 6 is a graph showing the distribution of a voltage signal $V_{2\omega}$ obtained by changing the phase difference $\Phi$ of the AC current flowing through the heaters 30a, 30b according to this embodiment. In the figure, the horizontal axis indicates the phase difference $\Phi$, and the vertical axis indicates the value of the obtained voltage signal $V_{2\omega}$. In the graph, the black dots indicate the measured data being plotted, and the solid line indicates the fitting curve of [Formula 7]. As shown in FIG. 6, the fitting curve by the function of the above-described [Formula 7] overlaps with the distribution of the measured data. Therefore, it can be confirmed that the distinct peak signal of the voltage signal $V^{2\omega}_{diff}$ detected in FIG. 5(c) is due to the nonlinear thermoelectric conversion by the second order term $a^{(2)}$ of the heat flow.

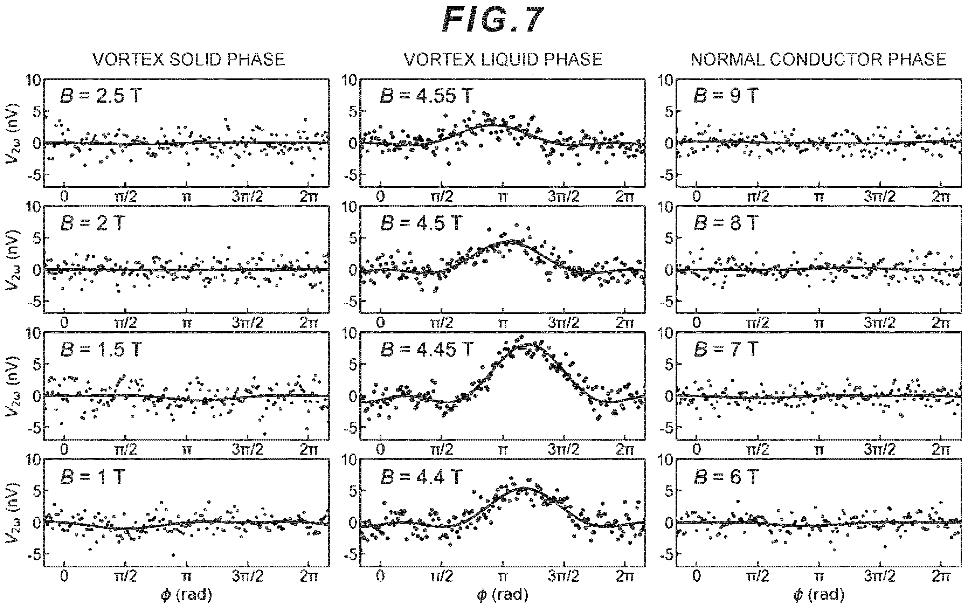

Figure 7 is a graph showing the distribution of voltage signal $V_{2\omega}$ at various magnetic fields B. The horizontal axis of each graph indicates the phase difference $\Phi$, and the vertical axis indicates the voltage signal $V_{2\omega}$. In the graph, the black dots indicate the measured data being plotted, and the solid line indicates a fitting curve. The left-hand column of FIG. 7 shows a vortex solid phase (vortex string being pinned) at B=1T, 1.5T, 2T, and 2.5T below the critical magnetic field and a fitting curve which is not the one shown with [Formula 7]. The center column of FIG. 7 shows a vortex liquid phase (vortex string being movable) at B=4.4T, 4.45T, 4.5T, and 4.55T in the vicinity of the critical magnetic field and a fitting curve which is the one shown with [Formula 7]. The righthand column of FIG. 7 shows a normal conducting phase at B=6T, 7T, 8T, and 9T above the critical field and a fitting curve which is not the one shown with [Formula 7]. Therefore, it can be confirmed that the distinct peak signal of the voltage signal $V^{2\omega}_{diff}$ detected in FIG. 5(c) is a nonlinear vortex Nernst effect induced in the vortex string by the second order term of the heat flow.

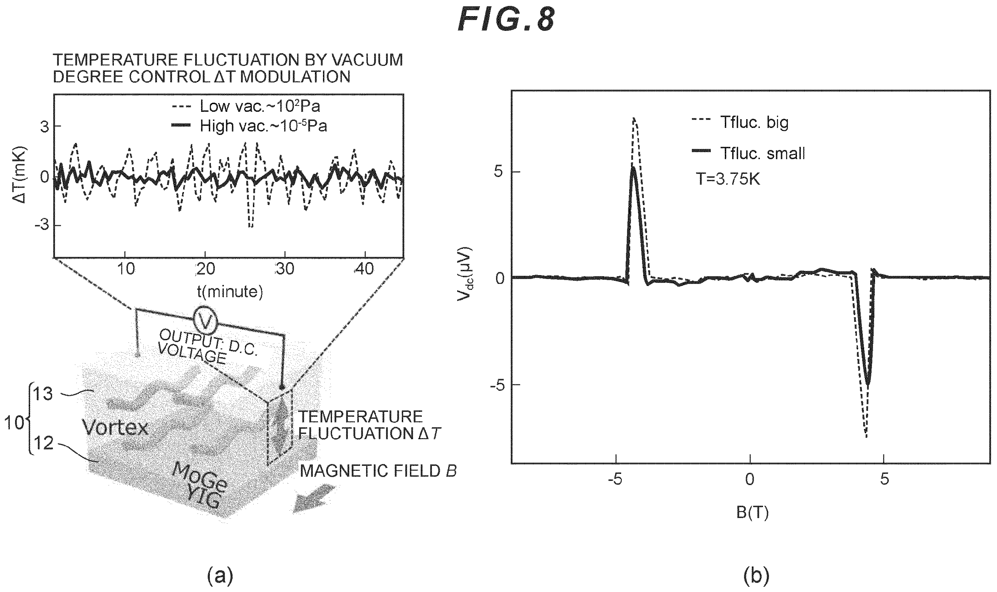

FIG. 8 is a diagram showing spontaneous power generation caused in the sample 10 by temperature fluctuation. The upper side of FIG.8 (a) is a graph showing vacuum degree and temperature fluctuation. The lower side of FIG. 8 (a) is a schematic diagram showing dc voltage occurring in the sample 10. FIG.8 (b) is a graph showing dc voltage caused in the sample 10 by temperature fluctuation. In the graph shown in the upper side of FIG.8 (a), the horizontal axis indicates the passage of time, and the vertical axis indicates the fluctuation of temperature $\Delta T$. In the upper side of FIG.8(a), the solid line indicates a case of a low vacuum in which the degree of vacuum is approximately $10^2$Pa, and the broken line indicates a case of a high vacuum in which the degree of vacuum is approximately $10^{-5}$Pa. It can be seen that the temperature fluctuation occurring in the sample 10 held in a vacuum vessel is smaller in a high vacuum than in a low vacuum.

The graph of FIG. 8 (b) shows the plotting of only the voltage measured by the potential difference measuring unit 40 in a case where the current supplied from the temperature gradient generating unit 30 to the heaters 30a, 30b is assumed to be zero. In the graph, the horizontal axis indicates the magnetic field B, and the vertical axis indicates the measured result $V_{dc}$ of the potential difference measuring unit 40. In the graph, the dashed line indicates a case where the temperature fluctuation is large at low vacuum, and the solid line indicates a case where the temperature fluctuation is small at high vacuum. This suggests that voltage Vdc changes in association with the change of temperature fluctuation and that electric power is generated by a nonlinear thermoelectric effect.

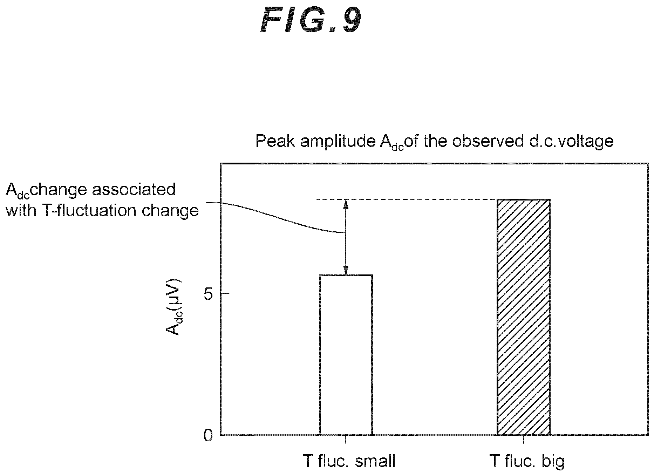

FIG.9 is a graph showing a peak amplitude $A_{dc}$ of dc voltage due to the temperature fluctuation in FIG.8. The vertical axis of FIG. 9 indicates the peak amplitude $A_{dc}$ in which the amount of change of the voltage $V_{dc}$ is the largest value. In the examples shown in FIGS. 8 and 9, the peak amplitude $A_{dc}$ is small when the temperature fluctuation is small in a high vacuum, and the peak amplitude $A_{dc}$ is large when the temperature fluctuation is large in a low vacuum. Therefore, by detecting a change in the peak-amplitude $A_{dc}$, a change in temperature fluctuation in the sample 10 can be detected.

FIG. 8 and FIG. 9 show examples where the peak amplitude $A_{dc}$ is small when the temperature fluctuation is small and the peak amplitude $A_{dc}$ is large when the temperature fluctuation is large. Alternatively, it is possible to use a sample that exhibits a large peak amplitude $A_{dc}$ when the temperature fluctuation is small and a small peak amplitude $A_{dc}$ when the temperature fluctuation is large. Similarly, in this alternative case, the temperature fluctuation sensor can detect the change in temperature fluctuation in the sample 10 by detecting the change in the peak-amplitude $A_{dc}$.

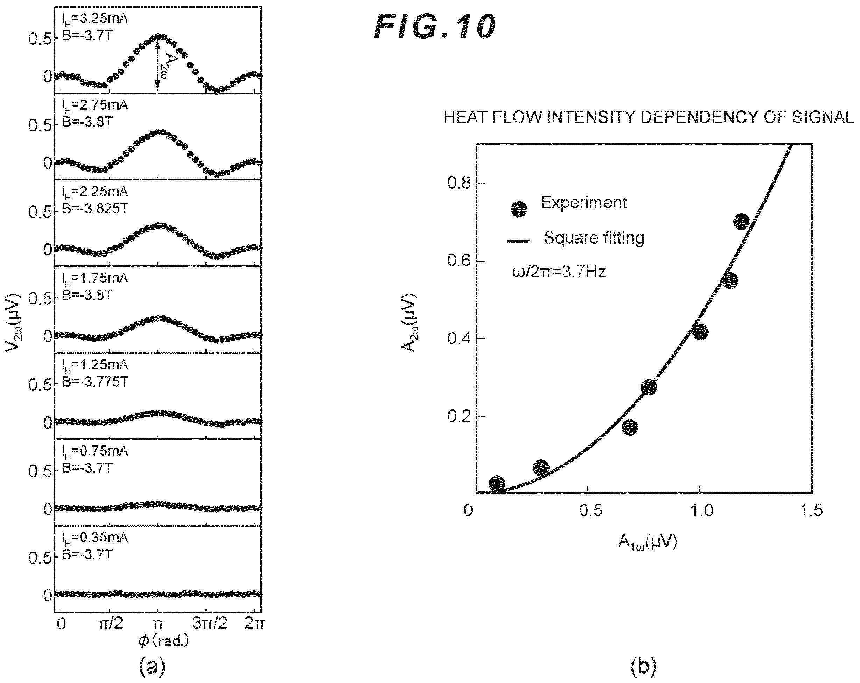

FIG.10 is a graph showing a relationship between the distribution of the magnitude of heat flow and a voltage signal $V_{2\omega}$. FIG.10 (a) shows the distribution of a voltage signal $V_{2\omega}$ by various current values applied to heaters 30a, 30b. FIG.10(b) shows the relationship between the linear thermoelectric signal intensity and the nonlinear thermoelectric signal intensity. In FIG.10(a), the horizontal axis indicates the phase difference $\Phi$, and the vertical axis indicates the voltage signal $V_{2\omega}$. The magnetic field B is measured in a range from -3.7 T to -3.825 T and measured by changing the effective current value $I_H$ flowing in the heaters 30a, 30b from 0.35 mA to 3.25 mA. When the effective current value $I_H$ flowing through the heaters 30a, 30b increases, the temperature gradient and the heat flow strength applied to the sample 10 increase. Thereby, the magnitude of the curve shown with [Formula 7] also increases.

The difference between the maximum and minimum values of the voltage signal $V_{2\omega}$ in the graph shown in FIG.10a is assumed as the nonlinear thermoelectric signal intensity $A_{2\omega}$. In addition, the amplitude of FIG.5(a) corresponding to the first order term $a^{(1)}$ in [Formula 3] is assumed as the linear thermoelectric signal intensity $A_{1\omega}$. In FIG.10b, the horizontal axis indicates the linear thermoelectric signal intensity $A_{1\omega}$, and the vertical axis indicates the nonlinear thermoelectric signal intensity $A_{2\omega}$. The graph of FIG. 10 (b) shows the results of calculating $A_{1\omega}$ and $A_{2\omega}$ for each effective current value $I_H$ and plotting the calculations. In the graph, the solid line indicates the quadratic function fitted by using the least squares method. Here, the relationship between $A_{1\omega}$ and $A_{2\omega}$ is expressed by [Formula 8] assuming that the coefficient $\beta$ of the quadratic function is a nonlinear thermoelectric coefficient. The calculation of the nonlinear thermoelectric coefficient $\beta$ is performed by the intensity calculating unit 70.

[Formula 8]

$$A_{2\omega} \propto \beta \left( A_{1\omega} \right)^2$$

In the exemplary embodiment shown in FIG.10 (b), the nonlinear thermoelectric coefficient calculated by the intensity calculating unit 70 is $\beta = 4.5 \times 10^5 m^{-2}kg^{-1}s^3A$. Therefore, it can be said that the sample 10 having the junction structure of the superconducting material layer 13 made of MoGe (which is a thermoelectric conversion part) and the magnetic insulating layer 12 (which is a spatial asymmetry part) is a temperature fluctuation energy harvesting element having a nonlinear thermoelectric coefficient of $\beta = 4.5 \times 10^5 m^{-2}kg^{-1}s^3A$.

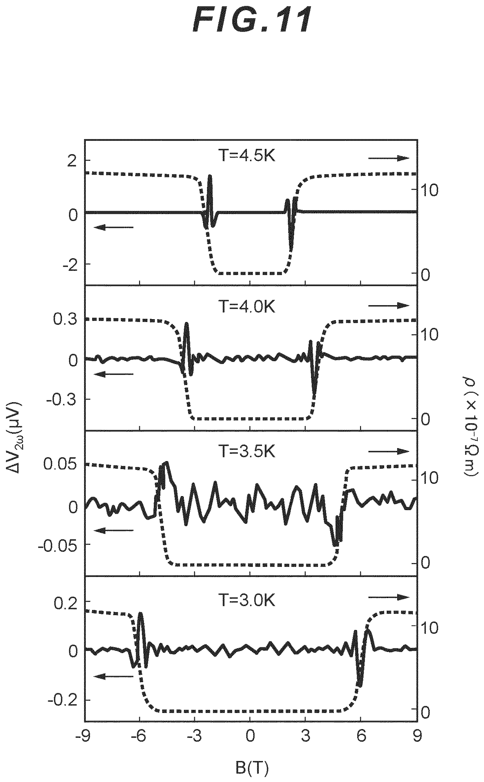

FIG. 11 is a graph showing the secondary measurement results of the heat flow at the lock-in detecting unit 50 at various temperatures. In the figure, the horizontal axis indicates the magnetic field B applied by the magnetic field applying unit 20, the left vertical axis indicates the measured voltage by the potential difference measuring unit 40, and the right vertical axis indicates the electrical resistance value. Because the critical magnetic field becomes large at low temperatures, the magnetic field where the peak signal of the voltage signal $V_{2\omega}$ appears also becomes large. As shown in FIG. 11, with the nonlinear thermoelectric effect measurement apparatus 100 of this embodiment, the nonlinear thermoelectric effect in the sample 10 can be detected regardless of the temperature.

As described above, the nonlinear thermoelectric effect measurement apparatus 100, the nonlinear thermoelectric effect measurement program, the recording medium, the temperature fluctuation energy harvesting element, and the temperature fluctuation sensor of this embodiment are provided with the magnetic field applying unit 20 for applying a magnetic field in the y-axis direction of the sample 10, the temperature gradient generating unit 30 for causing a temperature gradient in the z-axis direction, and the potential difference measuring unit 40 for measuring the potential difference V generated in the x-axis direction of the sample 10. The temperature gradient generating unit 30 includes the heater 30a provided on one surface of the sample 10 and the heater 30b provided on the other surface of the sample 10. By applying the first current $j_{c1} = L_{dc1} + I_1 \sin(\omega t + \Phi)$ and the second current $j_{c2} = I_{dc2} + I_2 \sin(\omega t)$, temperature fluctuation due to the nonlinear thermoelectric effect can be converted into electric energy and detected. Further, by measuring the voltage Vdc generated in the sample 10 and detecting the change in the peak amplitude $A_{dc}$, a configuration of a temperature fluctuation sensor for detecting temperature fluctuation can be obtained.

(Second embodiment)

Next, a second embodiment of the present invention is described. Contents overlapping with the first embodiment will not be described. In the first embodiment, the temperature fluctuation energy harvesting element is described having the junction structure formed of the superconducting material layer 13 (which is the thermoelectric conversion part) and the magnetic insulating layer 12 (which is the spatial asymmetry part). However, the thermoelectric conversion part and the spatial asymmetry part are not limited to the combination of the superconducting material layer 13 and the magnetic insulating layer 12. The options for the material of thermoelectric conversion part may include materials with large nonlinearities of electric conductivity such as Te, $MoS_2$, and ferromagnetic metal/paramagnetic metal bilayer films. Besides the above, ferromagnetic conductors belonging to polar point groups that break temporal/spatial inversion symmetry may be used as the material.

It is preferable that the combination of the thermoelectric conversion part and the spatial asymmetry part have a "broken spatial symmetry", and more preferable to have one of a "broken time reversal symmetry", a "Berry phase dipole mechanism", and an "asymmetric scattering mechanism by impurities or the like". In this case, the "broken spatial symmetry" means becoming asymmetric in a case where space is inverted with respect to the atomic arrangement in the thermoelectric conversion part. Further, "temperature fluctuation" means a spatial or temporal temperature inhomogeneity in the thermoelectric conversion part. Further, it is preferable that the thermoelectric conversion part has electrical conductivity. Further, the material that exhibits the broken time reversal symmetry may be a material including a magnetic material and an octapolar order material.

(Third embodiment)

Next, a third embodiment of the present invention is described. Contents overlapping with the first embodiment will not be described. In the first embodiment, the junction structure of the superconducting material layer 13 (which is the thermoelectric conversion part) and the magnetic insulating layer 12 (which is the spatial asymmetry unit) is described as the temperature fluctuation energy harvesting element. However, the thermoelectric conversion part and the spatial asymmetry part may be formed in the same material layer.

The material layer comprising the thermoelectric conversion part and the spatial asymmetry part may be a material having a molecular structure that achieves the nonlinear thermoelectric effect and also breaks spatial symmetry. Examples of such a material layer include those in which the crystal structure has no inversion symmetry and belongs to a polar point group or a chiral point group. More specifically, among the 32 point groups, the material may include a crystal structure in which the crystal structure itself belongs to a 21 point group without inversion symmetry and, among the 21 point groups, belongs to a polar point group (1, 2, m, mm2, 3, 3m, 4, 4mm, 6, 6mm) or a chiral point group (1, 2, 222, 4, 422, 3, 32, 6, 622, 23, 432). Further, in addition to having the above-described crystal structure, the material layer must satisfy at least one requirement of "broken time reversal symmetry", "Berry phase dipole mechanism", and "asymmetric scattering mechanism by impurities and the like".

In the case where the thermoelectric conversion part and the spatial asymmetry part of the temperature fluctuation energy harvesting element are formed in the same material layer, a temperature gradient is generated in the temperature gradient generating unit 30 in the direction in which the crystal structure of the material layer does not have the inversion symmetry. More specifically, the heaters 30a, 30b are provided on the front and back surfaces of the crystal structure of the material layer in the direction having no inversion symmetry, and the same current as that in the first embodiment is supplied to the heaters 30a, 30b. Further, a magnetic field is applied by the magnetic field applying unit 20 in a direction perpendicular to the temperature gradient direction, and the potential difference generated in a direction perpendicular to the temperature gradient direction and the magnetic field direction is measured by the potential difference measuring unit 40.

(Fourth embodiment)

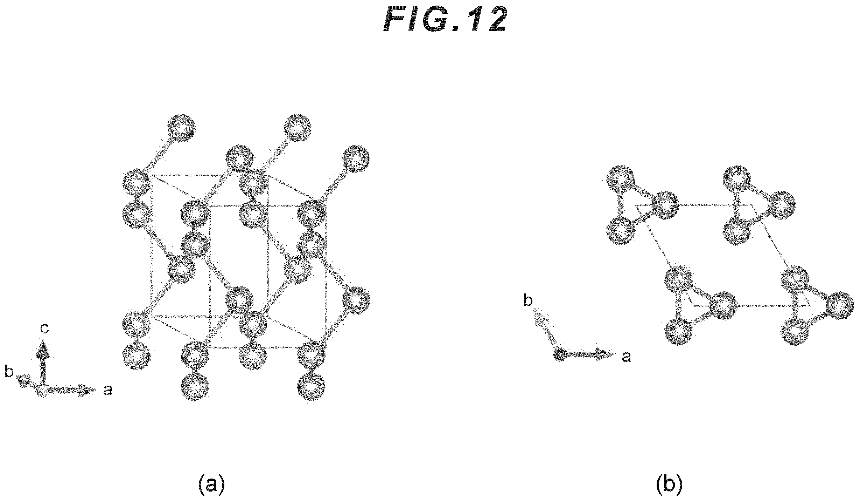

Next, a fourth embodiment of the present invention is described with reference to FIGS. 12 to 16. Contents overlapping with the first embodiment will not be described. This embodiment is different from the first embodiment in that Te having a crystal structure belonging to a chiral point group is used as the sample 10, and that the first and second terms of the Seebeck coefficients are confirmed by way of theoretical calculation.

FIG. 12 is a schematic diagram showing a crystal structure of Te which is used as a sample 10 according to this embodiment. In FIG.12, the spheres represent the Te atoms, and the lines connecting the Te atoms represent bonds. In FIG.12 (a), the vertical direction in the figure indicates the c-axis direction of the crystal structure, and the horizontal direction in the figure indicates the a-axis direction of the crystal structure. In FIG.12(b), the direction perpendicular to the paper surface indicates the c-axis direction of the crystal structure, the horizontal direction in the figure indicates the a-axis direction of the crystal structure, and the obliquely upper-leftward direction in the figure indicates the b-axis direction of the crystal structure. As shown in FIGS. 12(a)and 12(b), Te single crystals have a chiral structure in which three Te atoms are arranged in a triangular spiral with the c-axis as the helical axis. Therefore, the sample 10 made of Te single crystals corresponds to the spatial asymmetry part according to an embodiment of the present invention because the sample 10 has a structure that breaks the spatial symmetry in the c-axis direction.

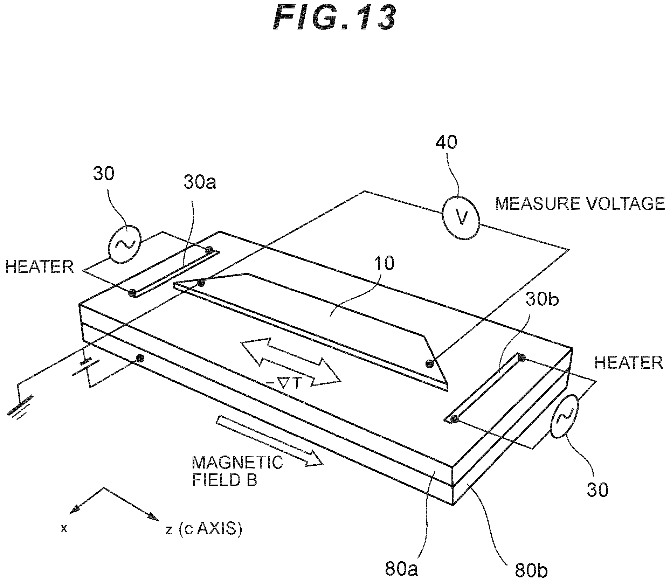

FIG.13 is a schematic diagram for explaining the measuring of a sample 10 according to this embodiment. In the example shown in FIG. 13, a Te single crystal used as the sample 10 is placed on a substrate made of an insulating layer 80a and a conductive layer 80b. As shown by the arrows of a coordinate system of FIG. 13, the longitudinal direction of the substrate is the z-axis direction and the width direction of the substrate is the x-axis direction. Further, the heaters 30a, 30b are provided on the front surface of the insulating layer 80a in a manner extending in the x-axis direction. Electrodes (not shown) are provided at both ends of the heaters 30a,30b in the x-axis direction, respectively.

A heater power supply of each temperature gradient generating unit 30 is connected to the electrodes provided at both ends of the heaters 30a, 30b, so that a current is supplied to the heaters 30a, 30b. Further, electrodes (not shown) are also formed at both ends in the z-axis direction of the sample 10 and connected to the potential difference measuring unit 40. The sample 10 is mounted on the substrate, so that the c-axis of the crystal structure is oriented in the z-axis direction and allows the magnetic field to be applied in the z-axis direction.

As in the first embodiment, the sample 10 is applied with an external magnetic field B in the z-axis direction, the electric field E is generated in the z-axis direction by the thermoelectric effect due to the temperature gradient $-\nabla T$. Here, the z-axis direction corresponds to the first direction according to this embodiment of the present invention. In a case where a nonlinear thermoelectric effect is occurring in the sample 10, the magnitude of the electric field E is different depending on whether the direction of the temperature gradient is in the positive direction or in the negative direction of the z-axis. Here, because the temperature gradient $-\nabla T$ is proportional to the heat flow jQ, the discussion concerning the heat flow jQ described in the first embodiment can be treated synonymously with the temperature gradient -VT. Therefore, obtaining the first order term $a^{(1)}$ and the second order term $a^{(2)}$ of the heat flow in the first embodiment is synonymous with obtaining the linear and nonlinear Seebeck coefficients $S^{(1)}$, $S^{(2)}$.

Because the sample 10 made of Te single crystals according to this embodiment is a layer in which a potential difference due to a thermoelectric effect occurs in the temperature gradient direction and the applied magnetic field direction, it corresponds to the thermoelectric converting part of the present invention. Therefore, the sample 10 according to this embodiment is provided with a thermoelectric conversion part that exhibits a nonlinear thermoelectric effect and a spatial asymmetry part that breaks the spatial symmetry of the thermoelectric conversion part. Thus, the sample 10 can be used as a temperature fluctuation energy harvesting element and a temperature fluctuation sensor according to an embodiment of the present invention.

Next, the first and second order terms of the temperature gradient will be discussed for Te single crystals of the sample 10. First, the Hamiltonian in Te single crystals, which is the sample 10, is defined by [Formula 9]. Here, "g" is a g-factor and "$\mu$B" is a Bohr magneton.

[Formula 9]

$$H_{\text{eff}} = -\Delta - C_1 k_z^2 - C_2(k_x^2 + k_y^2) + \chi \left[ \frac{\Delta}{\sqrt{k_x^2 + k_y^2}} (\sigma_x k_x + \sigma_y k_y) + \lambda k_z \sigma_z \right] - \frac{g\mu_{\text{B}}}{2} B_z \sigma_z$$

The following [Formula 10] is the Boltzmann's equation in a case where the electric field E is generated parallel to the c-axis of the sample 10. Here, "e" is the elementary quantity, and "$\tau$" is the relaxation time with a value dependent on, for example, the elementary quantity and substance.

[Formula 10]

$$-\frac{f - f_0}{\tau} = -eE \frac{\partial f}{\partial k_z}$$

Here, the first order term f1 and the second order term f2 are given by [Formula 11] in a case where the distribution function is $f=f0+f_1+f_2+ \cdots$, $f_n \propto E^n$, $f0:=1/(1+\exp(-\beta(E-\mu))$, $\beta =1/kBT$, "kB" is the Boltzmann constant, "T" is the temperature, and "$\mu$" is the chemical potential.

[Formula 11]

$$f_1 = e\tau E \frac{\partial f_0}{\partial k_z}$$

$$f_2 = e^2\tau^2 E^2 \frac{\partial^2 f_0}{\partial k_z^2}$$

Therefore, the first order term $j_e^{(1)}$ and the second order term $j_e^{(2)}$ of the current $j_e$ caused by the electric field are expressed by [Formula 12].

[Formula 12]

$$j_e^{(1)} = \int \frac{d^2k}{(2\pi)^2}\left(e\frac{\partial E^+(\boldsymbol{k}, B_z)}{\partial k_z}\right)f_1 = e^2\tau E \int \frac{d^2k}{(2\pi)^2}\frac{\partial E^+}{\partial k_z}\frac{\partial f_0}{\partial k_z} = -e^2\tau E \int \frac{d^2k}{(2\pi)^2}\frac{\partial^2 E^+}{\partial k_z^2}f_0$$

$$j_e^{(2)} = \int \frac{d^2k}{(2\pi)^2}\left(e\frac{\partial E^+(\boldsymbol{k}, B_z)}{\partial k_z}\right)f_2 = e^3\tau^2 E^2 \int \frac{d^2k}{(2\pi)^2}\frac{\partial E^+}{\partial k_z}\frac{\partial^2 f_0}{\partial k_z^2} = e^3\tau^2 E^2 \int \frac{d^2k}{(2\pi)^2}\frac{\partial^3 E^+}{\partial k_z^3}f_0$$

Here, we define that $\sigma^{(1)}$ and $\sigma^{(2)}$ without coefficients to be [Formula 13].

[Formula 13]

$$\sigma^{(1)} = -\int d^2k \frac{\partial^2 E^+}{\partial k_z^2}f_0$$

$$\sigma^{(2)} = \int d^2k \frac{\partial^3 E^+}{\partial k_z^3}f_0$$

The following [Formula 14] is the Boltzmann's equation in a case where the temperature gradient -∇T has occurred in parallel to the c-axis of the sample 10.

[Formula 14]

$$-\frac{f - f_0}{\tau} = \frac{\partial E^+}{\partial k_z}\frac{\partial f}{\partial z}$$

Here, the first order term $f_1$ and the second order term $f_2$ of $f = f_0 + f_1 + f_2 + \ldots$ are given by [Formula 15] in a case of assuming that $f_n \propto (-\nabla T)^n$.

[Formula 15]

$$f_1 = -\tau\left(-\frac{\partial_z T}{T}\right)(E^+ - \mu)\frac{\partial f_0}{\partial k_z}$$

$$f_2 = \tau^2\left(\frac{\partial_z T}{T}\right)^2(E^+ - \mu)^2\left(\frac{\partial E^+}{\partial k_z}\right)^2\frac{\partial^2 f_0}{\partial E^{+2}} + 2\tau^2\left(\frac{\partial_z T}{T}\right)^2(E^+ - \mu)\frac{\partial E^+}{\partial k_z}\frac{\partial f_0}{\partial k_z}$$

$$- \tau^2\frac{\partial_z^2 T}{T}(E^+ - \mu)\frac{\partial E^+}{\partial k_z}\frac{\partial f_0}{\partial k_z}$$

In a case where the temperature gradient is constant, the last term is eliminated because $\partial_z^2 T = 0$ and the first order term $j_e^{(1)}$ and the second order term $j_e^{(2)}$ of the current $j_e$ caused by the temperature gradient are expressed by [Formula 16].

## [Formula 16]

$$j_c^{(1)} = e\tau \left(-\frac{\partial_z T}{T}\right) \int \frac{d^2 k}{(2\pi)^2} \left[(E^+ - \mu)\frac{\partial^2 E^+}{\partial k_z^2} + \left(\frac{\partial E^+}{\partial k_z}\right)^2\right] f_0$$

$$j_c^{(2)} = e\tau^2 \left(\frac{\partial_z T}{T}\right)^2 \int \frac{d^2 k}{(2\pi)^2} \left[\left\{(E^+ - \mu)^2\frac{\partial^3 E^+}{\partial k_z^3} + 2(E^+ - \mu)\frac{\partial E^+}{\partial k_z}\frac{\partial^2 E^+}{\partial k_z^2}\right\} f_0 \right.$$
$$\left. - (E^+ - \mu)^2\frac{\partial E^+}{\partial k_z}\frac{\partial^2 E^+}{\partial k_z^2}\frac{\partial f_0}{\partial E^+}\right]$$

Here, $\alpha^{(1)}$ and $\alpha^{(2)}$ without coefficients are defined in [Formula 17].

## [Formula 17]

$$\alpha^{(1)} = \frac{1}{T} \int d^2 k \left[(E^+ - \mu)\frac{\partial^2 E^+}{\partial k_z^2} + \left(\frac{\partial E^+}{\partial k_z}\right)^2\right] f_0$$

$$\alpha^{(2)} = \frac{1}{T^2} \int d^2 k \left[\left\{(E^+ - \mu)^2\frac{\partial^3 E^+}{\partial k_z^3} + 2(E^+ - \mu)\frac{\partial E^+}{\partial k_z}\frac{\partial^2 E^+}{\partial k_z^2}\right\} f_0 - (E^+ - \mu)^2\frac{\partial E^+}{\partial k_z}\frac{\partial^2 E^+}{\partial k_z^2}\frac{\partial f_0}{\partial E^+}\right]$$

The current $j_z$ occurring in the c-axis direction of the sample 10 is the sum of the current $j_e$ due the electric field $E_z$ parallel to the c-axis direction and the current je due to the temperature gradient -VT and is expressed by [Formula18] by using $\sigma^{(1)}$, $\sigma^{(2)}$, $\alpha^{(1)}$, $\alpha^{(2)}$ defined with [Formula 12] [Formula 13] to [Formula 16] [Formula 17] .

## [Formula 18]

$$j_z = \sigma^{(1)} E_z + \sigma^{(2)} E_z^2 + \alpha^{(1)}(-\nabla T) + \alpha^{(2)}(-\nabla T)^2$$

Here, [Formula 19] is obtained by solving the quadratic equation with respect to $E_z$ assuming that the current $j_z$ = 0.

## [Formula 19]

$$E = \frac{-\sigma^{(1)} \pm \sqrt{\left(\sigma^{(1)}\right)^2 - 4\sigma^{(2)}\left[\alpha^{(1)}(-\nabla T) + \alpha^{(2)}(-\nabla T)^2\right]}}{2\sigma^{(2)}}$$

$$\simeq \frac{\alpha^{(1)}}{\sigma^{(1)}}\nabla T - \left[\frac{\alpha^{(2)}}{\sigma^{(1)}} + \frac{\sigma^{(2)}\left(\alpha^{(1)}\right)^2}{\left(\sigma^{(1)}\right)^3}\right](\nabla T)^2$$

Therefore, the linear first order term $S^{(1)}$ and the nonlinear second order term $S^{(2)}$ of the Seebeck coefficients are expressed by [Formula 20].

## [Formula 20]

$$S^{(1)} = \frac{\alpha^{(1)}}{\sigma^{(1)}}$$

$$S^{(2)} = -\frac{\alpha^{(2)}}{\sigma^{(1)}} - \frac{\sigma^{(2)}\left(\alpha^{(1)}\right)^2}{\left(\sigma^{(1)}\right)^3}$$

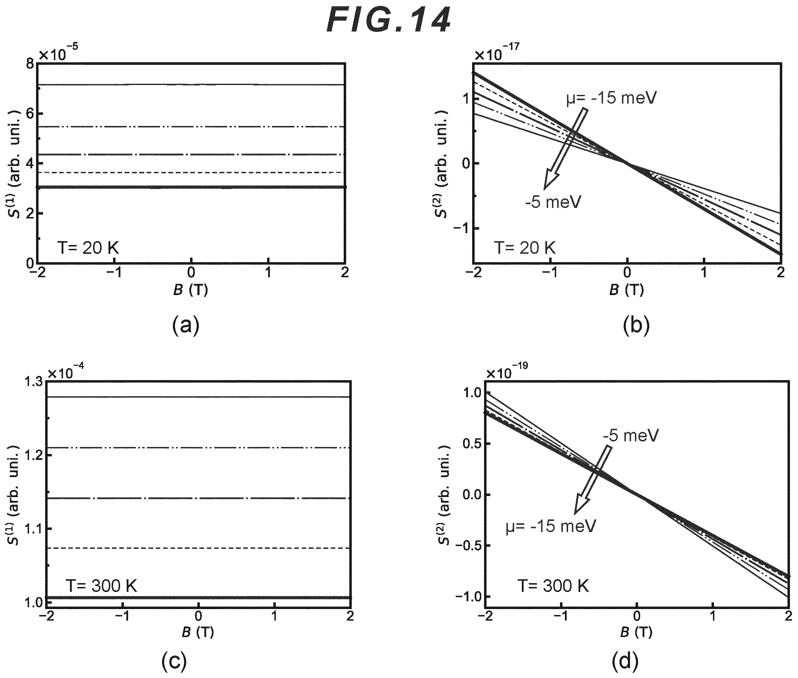

The results of performing numerical calculations with the above-described [Formula 20] are shown in FIGS. 14 to 16. FIG. 14 are graphs showing the magnetic field dependence of the linear and nonlinear Seebeck coefficients $S^{(1)}$, $S^{(2)}$. FIG. 14 (a) shows a first order term $S^{(1)}$ in 20K. FIG. 14 (b) shows a second order term $S^{(2)}$ in 20K. FIG. 14 (c) shows a first

order term $S^{(1)}$ in 300K. FIG. 14 (d) shows a second order term $S^{(2)}$ in 300K. In the figure, the horizontal axis indicates the magnetic field B, and the vertical axis represents the value of $S^{(1)}$ or $S^{(2)}$ (arbitrary unit). Each of the lines in the figure shows the calculated results when changing the chemical potential $\mu$ from -15meV to -5meV.

As shown in FIG. 14a and FIG. 14c, the first order term $S^{(1)}$ becomes a constant that is independent of the magnetic field B at low and high temperatures. Further, as shown in FIG. 14 (b) and FIG. 14 (d), the second order term $S^{(2)}$ becomes an odd function of the magnetic field B at low and high temperatures.

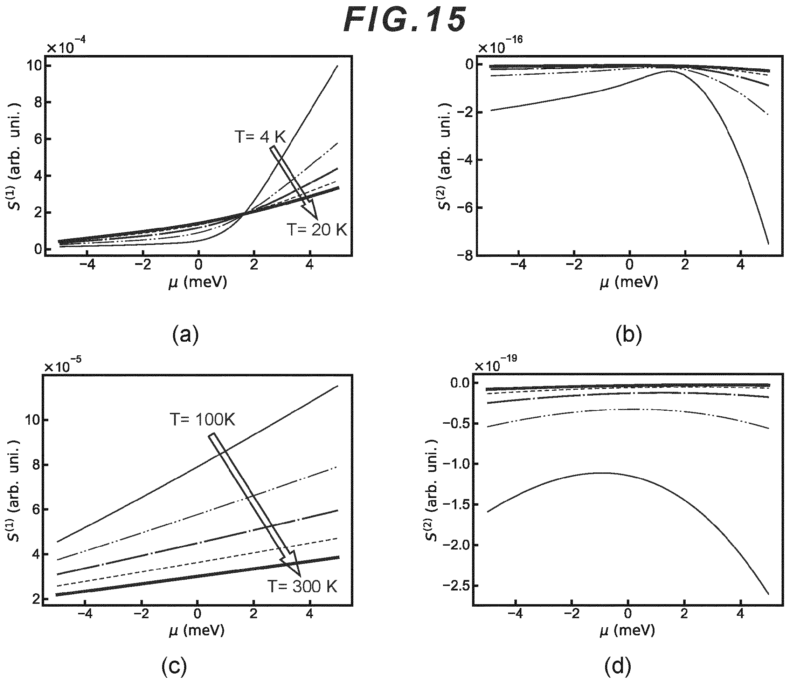

FIG. 15 are graphs showing the chemical potential dependence of linear and nonlinear Seebeck coefficients $S^{(1)}$, $S^{(2)}$. FIG.15(a) shows a first order term $S^{(1)}$ at low temperatures. FIG. 15(b) shows a second order term $S^{(2)}$ at low temperatures. FIG. 15(c) shows a first order term $S^{(1)}$ at high temperatures. FIG. 15(d) shows a second order term $S^{(2)}$ at high temperatures. Here, the magnetic field is B=2T. Further, in the figure, the horizontal axis indicates the chemical potential $\mu$, and the vertical axis indicates the value of $S^{(1)}$ or $S^{(2)}$ (arbitrary unit). In the measurement apparatus shown in FIG. 13, the chemical potential $\mu$ can be changed by changing the gate voltage applied between the conductive layer 80b and the sample 10. Each of the lines in FIG. 15 (a) (b) shows the calculated results when changing the temperature T from 4K to 20K. Each line in FIG. 15 (c) (d) shows the calculated results when changing the temperature T from 100K to 300K.

As shown in FIGS. 15(a) to 15(d), the first order term $S^{(1)}$ and the second order term $S^{(2)}$ change depending on the chemical potential $\mu$ at low and high temperatures. Further, the amount of change in the first order term $S^{(1)}$ or the second order term $S^{(2)}$ with respect to the amount of change in the chemical potential $\mu$ increases at lower temperatures.

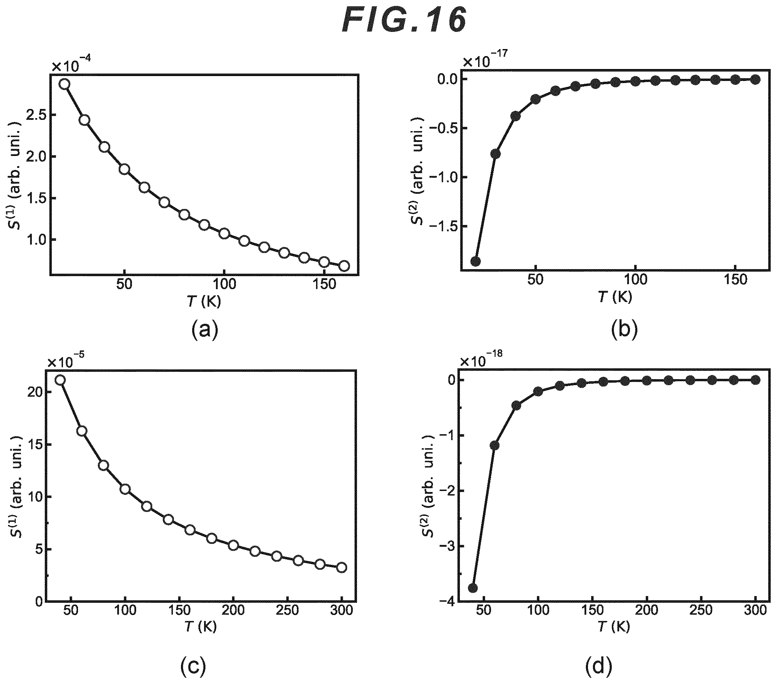

FIG. 16 are graphs showing the temperature dependence of the linear and nonlinear Seebeck coefficients $S^{(1)}$, $S^{(2)}$. FIG. 16 (a) shows a first order term $S^{(1)}$ in a low temperature range. FIG. 16 (b) shows a second order term $S^{(2)}$ in a low temperature range. FIG. 16 (c) shows a first order term $S^{(1)}$ in a high temperature range. FIG. 16 (d) shows a second order term $S^{(2)}$ in a high temperature range. Here, the chemical potential is $\mu$=4meV, and the magnetic field is B=2T. Further, the horizontal axis in the figure represents the temperature T, the vertical axis represents the value of $S^{(1)}$ or $S^{(2)}$ (arbitrary unit).

As shown in FIG. 16 (a) to FIG. 16 (d), the intensity of the first order term $S^{(1)}$ and the second order term $S^{(2)}$ in the low temperature region and the high temperature region, both increase monotonously by lowering the temperature T.

As shown in FIGS. 14 to 15, the second order term $S^{(2)}$ of the nonlinear Seebeck coefficient can be measured by using the nonlinear thermoelectric effect measurement apparatus and the nonlinear thermoelectric effect measurement method described in the first embodiment in the region where the second order term $S^{(2)}$ of the nonlinear Seebeck coefficient takes a finite value that is not zero. Further, the sample 10 can be used as a temperature fluctuation energy harvesting element by the nonlinear thermoelectric effect in the region where the second order term $S^{(2)}$ of the nonlinear Seebeck coefficient takes a finite value that is not zero. Further, it is possible to constitute a temperature fluctuation sensor for detecting temperature fluctuation by measuring the voltage Vdc generated in the sample 10 and detecting a change in the peak amplitude $A_{dc}$.

The present invention is not limited to the above-described embodiments, and various changes can be made within the scope shown in the claims, and embodiments obtained by appropriately combining the technical parts/units disclosed respectively in the different embodiments are also included in the technical scope of the present invention.

**Description of the reference numerals**

100... Nonlinear thermoelectric effect measurement apparatus
10... Sample
20... Magnetic field applying unit
30... Temperature gradient generating unit
40... Potential difference measuring part
50... Lock-in detecting unit
60... Phase change measuring unit
70... Intensity calculating unit
11... Substrate
12... Magnetic insulating layer
13... Superconducting material layer
30a,30b... heaters
31a,31b... electrodes
80a... insulating layer
80b... conductive layer

**Claims**

1. A nonlinear thermoelectric effect measurement apparatus for measuring a nonlinear thermoelectric effect occurring in a sample, the nonlinear thermoelectric effect measurement apparatus comprising:

   a temperature gradient generating unit configured to cause a temperature gradient in the sample; and
   a potential difference measuring unit configured to measure a potential difference V generated in the sample;
   wherein the temperature gradient generating unit includes a first heating part provided on one surface of the sample and a second heating part provided on the other surface facing the one surface of the sample and is configured to apply a first current $j_{c1}=I_{dc1}+I_1\sin(\omega t + \Phi)$ to the first heating part and a second current $j_{c2}=I_{dc2}+I_2\sin(wt)$ to the second heating part.

2. The nonlinear thermoelectric effect measurement apparatus according to claim 1, further comprising: a magnetic field applying unit configured to apply a magnetic field to the sample.

3. The nonlinear thermoelectric effect measurement apparatus according to claim 1 or 2, further comprising: a lock-in detecting unit configured to detect a component $V_{2\omega}$ of frequency $2\omega$ with respect to the potential difference V.

4. The nonlinear thermoelectric effect measurement apparatus according to claim 3, further comprising: a phase change measuring unit configured to obtain the distribution of the component $V_{2\omega}$ by changing the $\Phi$.

5. The nonlinear thermoelectric effect measurement apparatus according to claim 4, further comprising: an intensity calculating unit configured to calculate a nonlinear thermoelectric intensity $\beta$ based on the distribution of the component $V_{2\omega}$ obtained by the phase change measuring unit.

6. A nonlinear thermoelectric effect measurement method for measuring a nonlinear thermoelectric effect occurring in a sample, the nonlinear thermoelectric effect measurement method comprising:

   a temperature gradient generating step for causing a temperature gradient in the sample; and
   a potential difference measuring step for measuring the potential difference V generated in the sample;
   wherein the temperature gradient generating step includes applying a first current $j_{c1}=I_{dc1}+I_1\sin(\omega t + \Phi)$ to a first heating part provided on one surface of the sample and applying a second current $j_{c2}=I_{dc2}+I_2\sin(wt)$ to a second heating part provided on the other surface facing the one surface of the sample.

7. A nonlinear thermoelectric effect measurement program for measuring a nonlinear thermoelectric effect occurring in a sample, the nonlinear thermoelectric effect measurement program causing a computer to perform the steps comprising:

   a temperature gradient generating step for causing a temperature gradient in the sample by applying a first current $j_{c1}=I_{dc1}+I_1\sin(\omega t + \Phi)$ to a first heating part provided on one surface of the sample and applying a second current $j_{c2}=I_{dc2}+I_2\sin(wt)$ to a second heating part provided on the other surface facing the one surface of the sample; and
   a potential difference measuring step for measuring the potential difference V generated in the sample.

8. A computer-readable recording medium comprising the nonlinear thermoelectric effect measurement program of claim 7.

9. A temperature fluctuation energy harvesting element comprising:

   a thermoelectric conversion part configured to generate a potential difference from a temperature fluctuation due to a nonlinear thermoelectric effect; and
   a spatial asymmetry part configured to break a spatial symmetry of the thermoelectric conversion part.

10. The temperature fluctuation energy harvesting element according to claim 9,

    wherein the thermoelectric conversion part and the spatial asymmetry part are composed of different materials, and
    wherein the thermoelectric conversion part and the spatial asymmetry part form a junction structure.

11. The temperature fluctuation energy harvesting element according to claim 9,

wherein the thermoelectric conversion part and the spatial asymmetry part are formed in the same material layer, and
wherein the material layer includes a crystal structure that has no inversion symmetry and belongs to a polar point group or chiral point group.

12. A temperature fluctuation sensor comprising:

a thermoelectric conversion part configured to generate a potential difference from a temperature fluctuation due to a nonlinear thermoelectric effect; and
a spatial asymmetry part configured to break a spatial symmetry of the thermoelectric conversion part.

13. The temperature fluctuation sensor according to claim 12,

wherein the thermoelectric conversion part and the spatial asymmetry part are composed of different materials, and
wherein the thermoelectric conversion part and the spatial asymmetry part form a junction structure.

14. The temperature fluctuation sensor according to claim 12,

wherein the thermoelectric conversion part and the spatial asymmetry part are formed in the same material layer, and
wherein the material layer includes a crystal structure that has no inversion symmetry and belongs to a polar point group or chiral point group.

# FIG.1

# FIG.2

```
            ┌─────────────┐
            │    START    │
            └─────────────┘
                   │
                   ▼
        ┌───────────────────┐
        │  APPLY MAGNETIC   │─── S1
        │      FIELD        │
        └───────────────────┘
                   │
                   ▼
        ┌───────────────────┐
        │     GENERATE      │─── S2
        │   TEMPERATURE     │
        │     GRADIENT      │
        └───────────────────┘
                   │
                   ▼
        ┌───────────────────┐
        │ MEASURE POTENTIAL │─── S3
        │    DIFFERENCE     │
        └───────────────────┘
                   │
                   ▼
        ┌───────────────────┐
        │  DETECT LOCK-IN   │─── S4
        └───────────────────┘
                   │
                   ▼
        ┌───────────────────┐
        │   MEASURE PHASE   │─── S5
        │      CHANGE       │
        └───────────────────┘
                   │
                   ▼
        ┌───────────────────┐
        │    CALCULATE      │─── S6
        │    INTENSITY      │
        └───────────────────┘
                   │
                   ▼
            ┌─────────────┐
            │     END     │
            └─────────────┘
```

**FIG.3**

(b)

ELECTRIC FIELD $E$

HEAT FLOW $j_Q$

MAGNETIC FIELD $B$

Vortex

MoGe
YIG

13

12

(a)

40

30

31a

HEATER

MoGe
YIG

GGG

$B$

31a

13
12
11

10

30a

31b

30b

30

$z$  $x$  $y$

# FIG.4

(a)

(b)

(c)

(d)

EP 4 642 211 A1

# FIG.5

FIRST ORDER OF HEAT FLOW

VORTEX LIQUID PHASE

(a)

RESULT OF $4_\omega$ MEASUREMENT

VORTEX LIQUID PHASE

(b)

RESULT OF $2_\omega$ MEASUREMENT
(SECOND ORDER OF HEAT FLOW)

VORTEX LIQUID PHASE

(c)

# FIG.6

FIG.7

EP 4 642 211 A1

## FIG.8

TEMPERATURE FLUCTUATION BY VACUUM
DEGREE CONTROL ΔT MODULATION

- - - Low vac.~$10^2$Pa
— High vac.~$10^{-5}$Pa

OUTPUT: D.C.
VOLTAGE

13
10
12

Vortex

MoGe
YIG

TEMPERATURE
FLUCTUATION ΔT

MAGNETIC FIELD B

(a)

- - - Tfluc. big
— Tfluc. small
T=3.75K

(b)

EP 4 642 211 A1

# FIG.9

Peak amplitude A$_{dc}$ of the observed d.c.voltage

A$_{dc}$change associated
with T-fluctuation change

A$_{dc}$(μV)

5

0

T fluc. small          T fluc. big

# FIG.10

(a)

HEAT FLOW INTENSITY DEPENDENCY OF SIGNAL

- ● Experiment
- —— Square fitting

$\omega/2\pi = 3.7\text{Hz}$

(b)

EP 4 642 211 A1

# FIG.11

# FIG.12

(a)

(b)

# FIG.13

FIG.14

(a)

(b)

(c)

(d)

EP 4 642 211 A1

# FIG.15

(a)

(b)

(c)

(d)

EP 4 642 211 A1

FIG. 16

## INTERNATIONAL SEARCH REPORT

| | International application No. |
|---|---|
| | **PCT/JP2023/044536** |

| A. | CLASSIFICATION OF SUBJECT MATTER |
|---|---|

*H10N 15/00*(2023.01)i; *G01N 27/00*(2006.01)i; *H10N 10/10*(2023.01)i
FI:    H10N15/00; G01N27/00 D; H10N10/10 C

According to International Patent Classification (IPC) or to both national classification and IPC

| B. | FIELDS SEARCHED |
|---|---|

Minimum documentation searched (classification system followed by classification symbols)

H10N15/00; G01N27/00; H10N10/10

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2020-134237 A (THE NATIONAL INSTITUTE OF ADVANCED INDUSTRIAL SCIENCE AND TECHNOLOGY) 31 August 2020 (2020-08-31)<br>      paragraphs [0017]-[0020], fig. 1, 2 | 1, 2, 6-8 |
| A | | 3-5, 9-14 |
| Y | JP 2009-529909 A (KONINKLIJKE PHILIPS ELECTRONICS N.V) 27 August 2009 (2009-08-27)<br>      paragraphs [0052], [0094], fig. 13 | 1, 2, 6-8 |
| X | 西川 尚ほか, ワイル金属薄膜の熱電特性, 日本物理学会講演概要集, 2018, vol. 73.1, p. 930, (NISHIKAWA, Takashi et al. Thermoelectric properties of a Weyl metal thin film. Meeting Abstracts of the Physical Society of Japan.)<br>      p. 930, lines 1-26 | 9, 11 |
| Y | | 1, 2, 6-8, 12, 14 |
| A | | 3-5, 10, 13 |

| ✓ Further documents are listed in the continuation of Box C. | ✓ See patent family annex. |
|---|---|

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **15 February 2024** | **27 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

International application No.

**PCT/JP2023/044536**

| C. | DOCUMENTS CONSIDERED TO BE RELEVANT | |
|---|---|---|
| Category* | Citation of document, with indication, where appropriate, of the relevant passages | Relevant to claim No. |
| Y | WO 2021/187347 A1 (NATIONAL INSTITUTE FOR MATERIALS SCIENCE) 23 September 2021 (2021-09-23)<br>paragraphs [0030]-[0032], fig. 6 | 12, 14 |
| A | JP 2000-074862 A (SHARP KABUSHIKI KAISHA) 14 March 2000 (2000-03-14)<br>paragraphs [0024]-[0042], fig. 1, 2 | 1-14 |
| A | 山本 薫ほか, 量子熱電素子の熱効率：時間反転対称性の破れと非弾性散乱の効果, 日本物理学会講演概要集, 2016, vol. 71.2, p. 2839, (YAMAMOTO, Kaoru et al. The efficiency of quantum thermoelectricity; effects of a broken time-reversal symmetry and inelastic scatterings. Meeting Abstracts of the Physical Society of Japan.)<br>p. 2839, lines 1-13, fig. 1, 2 | 1-14 |

Form PCT/ISA/210 (second sheet) (July 2022)

## INTERNATIONAL SEARCH REPORT

| International application No. |
| --- |
| **PCT/JP2023/044536** |

**Box No. III    Observations where unity of invention is lacking (Continuation of item 3 of first sheet)**

This International Searching Authority found multiple inventions in this international application, as follows:

Claims are classified into two inventions below.

(Invention 1) Claims 1-8

Claims 1-8 have the special technical feature of "comprising: a temperature gradient generation unit that generates a temperature gradient in the sample; and a potential difference measurement unit that measures a potential difference V generated in the sample, wherein the temperature gradient generation unit includes a first heating unit that is provided on one surface of the sample and a second heating unit that is provided on the other surface facing the one surface of the sample, a first current $j_{c1} = I_{dc1} + I_1 sin(\omega t + \Phi)$ is applied to the first heating unit, and a second current $j_{c2} = I_{dc2} + I_2 sin(\omega t)$ is applied to the second heating unit," and are thus classified as invention 1.

Claims 6-8 have the technical feature identical or corresponding to claim 1 classified as invention 1, and thus are classified as invention 1.

(Invention 2) Claims 9-14

It cannot be said that claims 9-11 have the technical feature identical or corresponding to claim 1 classified as invention 1.

Claims 9-11 are not dependent on claim 1. Claims 9-11 are not substantially identical to or similarly closely related to any of the claims classified as invention 1.

Therefore, claims 9-11 cannot be classified as invention 1.

Document 3 discloses a "temperature fluctuation environment power generation element comprising: a thermoelectric conversion unit that generates a potential difference from a temperature fluctuation on the basis of nonlinear thermoelectric effect; and a spatial asymmetric unit that breaks spatial asymmetry of the thermoelectric conversion unit," and claim 9 lacks novelty in light of document 3, and does not have a special technical feature. However, claim 10 dependent on claim 9 has the special technical feature in which the "thermoelectric conversion unit and the spatial asymmetric unit are formed of different materials, and have a junction structure of thermoelectric conversion unit and the spatial asymmetric unit." Therefore, claims 9 and 10 are classified as invention 2.

Claim 11 is dependent on claim 9, inventively related to claim 9, and is thus classified as invention 2.

Claims 12-14 have the technical feature identical or corresponding to claims 9-11 classified as invention 2, and thus are classified as invention 2.

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**   ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (July 2022)

INTERNATIONAL SEARCH REPORT
Information on patent family members

International application No.

**PCT/JP2023/044536**

| Patent document cited in search report | | | Publication date (day/month/year) | Patent family member(s) | | | Publication date (day/month/year) |
|---|---|---|---|---|---|---|---|
| JP | 2020-134237 | A | 31 August 2020 | (Family: none) | | | |
| JP | 2009-529909 | A | 27 August 2009 | US | 2010/0156444 | A1 | |
| | | | | paragraphs [0052], [0101], fig. 13 | | | |
| | | | | WO | 2007/107947 | A1 | |
| | | | | CN | 101405409 | A | |
| WO | 2021/187347 | A1 | 23 September 2021 | US | 2023/0102920 | A1 | |
| | | | | paragraphs [0073]-[0075], fig. 6 | | | |
| | | | | EP | 4123897 | A1 | |
| JP | 2000-074862 | A | 14 March 2000 | (Family: none) | | | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015144212 A